# EUROPEAN PATENT APPLICATION

(11) **EP 4 851 648 A1**
(43) Date of publication of application: **09.12.2026**
(21) Application number: 25748152.3
(22) Date of filing: 27.01.2025
(51) Int. Cl.: G01R 31/389, G01R 27/02

(54) **DRIVE MEASUREMENT CIRCUIT, IMPEDANCE MEASUREMENT DEVICE, IMPEDANCE MEASUREMENT SYSTEM, AND DRIVE MEASUREMENT METHOD**

(30) Priority: 31.01.2024 US 202463627594 P
(71) Applicant: Nuvoton Technology Corporation Japan, Nagaokakyo City, Kyoto 617-8520 (JP)
(72) Inventor: OKADA, Yu, Nagaokakyo City, Kyoto 617-8520 (JP); MIHASHI, Tetsuya, Nagaokakyo City, Kyoto 617-8520 (JP); ISHII, Takuya, Nagaokakyo City, Kyoto 617-8520 (JP)
(74) Representative: Appelt, Christian W.
(86) International application number: PCT/JP2025/002429
(87) International publication number: WO 2025/164570

(57) **Abstract**

A drive measurement circuit (2) includes: a current measurer (21) that measures current through a first battery (B1) and current through a second battery (B2); a voltage measurer (20) that measures voltage of the first battery (B1) and voltage of the second battery (B2); an AC detector (22) that receives, from a higher-level system (200) having a function to calculate AC impedance, a measurement instruction signal including information on a measurement frequency, measures AC voltage and AC current corresponding to the measurement frequency, based on a measurement result obtained by the voltage measurer (20) and a measurement result obtained by the current measurer (21), and outputs the AC voltage and the AC current to the higher-level system (200); and a drive controller (23) that drives the plurality of switching elements to periodically change, in accordance with the measurement frequency, a state of electrical energy transfer via an inductor (14).

## Description

### [Technical Field]

The present disclosure relates to, for instance, a drive measurement circuit that controls an impedance measurement device that measures alternating-current (AC) impedance of a plurality of batteries connected in series.

### [Background Art]

AC impedance is a parameter used to determine the battery condition. According to the impedance measurement method disclosed in Patent Literature (PTL) 1, AC current at a first reference frequency is superimposed on a battery, the battery voltage and current are measured at a sampling frequency sufficiently higher than the first reference frequency and converted into digital values, and each of the digital values is converted into the real and imaginary components of complex voltage and complex current by multiplying the digital value by a first reference-frequency signal and by a second reference-frequency signal having a phase orthogonal to the first reference-frequency signal (for example, the first reference-frequency signal is a sine wave and the second reference-frequency signal is a cosine wave). Data of the components are further integrated (averaged) to reduce measurement error, retained, and conveyed to a higher-level system. The higher-level system includes a central processing unit (CPU), calculates the AC impedance by dividing the complex voltage component by the complex current component, and further sweeps the first reference frequency (in the low-frequency range of 0.01 Hz to several tens of kHz) to determine the battery condition from the frequency characteristics of the AC impedance.

As a method of superimposing AC current at the first reference frequency on the battery, it is known to efficiently superimpose AC current by applying, to the battery, high-frequency current pulses, whose frequency is sufficiently higher than the first reference frequency. In the impedance measurement device disclosed in PTL 2, a switching circuit that forms a loop circuit with a battery generates a current that intermittently flows at high frequency. The switching circuit includes: a first switch and a second switch that are inserted in series in the loop circuit; an inductor and an energy storage device connected in series with each other and in parallel with the second switch; and a drive controller that controls and drives the first switch and the second switch. By the drive controller alternately turning the first switch and the second switch on and off at a predetermined duty cycle, pulsed current can be supplied from the battery to charge the energy storage device. By repeating the switching operation period and the switching operation stop period, the flowing current and the battery voltage are measured, and the AC impedance corresponding to the repetition frequency, that is, the first reference frequency, is calculated. Further, by supplying a pulsed current that regeneratively flows from the energy storage device to the battery, the voltage of the energy storage device can be controlled within a predetermined range while inhibiting changes in the battery capacity.

### [Citation List]

### [Patent Literature]

[PTL 1] International Publication No. WO 2020/261799
[PTL 2] International Publication No. WO 2023/127478

### [Summary of Invention]

### [Technical Problem]

However, the method disclosed in PTL 2 requires components such as an inductor and an energy storage device (capacitor), resulting in a problem of increased size of the impedance measurement device.

Accordingly, the present disclosure provides, for instance, a drive measurement circuit that can miniaturize the impedance measurement device.

### [Solution to Problem]

A drive measurement circuit according to an aspect of the present disclosure is a drive measurement circuit that controls an impedance measurement device that measures alternating-current (AC) impedance of a first battery and AC impedance of a second battery, the first battery and the second battery being connected in series. The impedance measurement device includes: an energy storage element that stores or releases electrical energy; a switching circuit that intermittently transfers, via the energy storage element, electrical energy between the first battery and the second battery, the switching circuit including a plurality of switching elements; and a current detector that detects current through the first battery and current through the second battery, and the drive measurement circuit includes: a current measurer that measures the current through the first battery and the current through the second battery, based on a detection result obtained by the current detector; a voltage measurer that measures voltage of the first battery and voltage of the second battery; an AC detector that receives, from a higher-level system having a function to calculate AC impedance, a measurement instruction signal including information on a measurement frequency, measures AC voltage and AC current corresponding to the measurement frequency, based on a measurement result obtained by the voltage measurer and a measurement result obtained by the current measurer, and outputs the AC voltage measured and the AC current measured to the higher-level system; and a drive controller that drives the plurality of switching elements to periodically change, in accordance with the measurement frequency, a state of electrical energy transfer via the energy storage element.

An impedance measurement device according to an aspect of the present disclosure is an impedance measurement device that measures alternating-current (AC) impedance of a first battery and AC impedance of a second battery, the first battery and the second battery being connected in series, the impedance measurement device including: an energy storage element that stores or releases electrical energy; a switching circuit that intermittently transfers, via the energy storage element, electrical energy between the first battery and the second battery, the switching circuit including a plurality of switching elements; a current detector that detects current through the first battery and current through the second battery; and a drive measurement circuit. The drive measurement circuit includes: a current measurer that measures the current through the first battery and the current through the second battery, based on a detection result obtained by the current detector; a voltage measurer that measures voltage of the first battery and voltage of the second battery; an AC detector that receives, from a higher-level system having a function to calculate AC impedance, a measurement instruction signal including information on a measurement frequency, measures AC voltage and AC current corresponding to the measurement frequency, based on a measurement result obtained by the voltage measurer and a measurement result obtained by the current measurer, and outputs the AC voltage measured and the AC current measured to the higher-level system; and a drive controller that drives the plurality of switching elements to periodically change, in accordance with the measurement frequency, a state of electrical energy transfer via the energy storage element.

An impedance measurement system according to an aspect of the present disclosure is an impedance measurement system including: an impedance measurement device that measures alternating-current (AC) impedance of a first battery and AC impedance of a second battery, the first battery and the second battery being connected in series; a drive measurement circuit that controls the impedance measurement device; and a higher-level system having a function to calculate AC impedance. The impedance measurement device includes: an energy storage element that stores or releases electrical energy; a switching circuit that intermittently transfers, via the energy storage element, electrical energy between the first battery and the second battery, the switching circuit including a plurality of switching elements; and a current detector that detects current through the first battery and current through the second battery. The drive measurement circuit includes: a current measurer that measures the current through the first battery and the current through the second battery, based on a detection result obtained by the current detector; a voltage measurer that measures voltage of the first battery and voltage of the second battery; an AC detector that receives, from the higher-level system, a measurement instruction signal including information on a measurement frequency, measures AC voltage and AC current corresponding to the measurement frequency, based on a measurement result obtained by the voltage measurer and a measurement result obtained by the current measurer, and outputs the AC voltage measured and the AC current measured to the higher-level system; and a drive controller that drives the plurality of switching elements to periodically change, in accordance with the measurement frequency, a state of electrical energy transfer via the energy storage element.

A drive measurement method according to an aspect of the present disclosure is a drive measurement method for controlling an impedance measurement device that measures alternating-current (AC) impedance of a first battery and AC impedance of a second battery, the first battery and the second battery being connected in series. The impedance measurement device includes: an energy storage element that stores or releases electrical energy; a switching circuit that intermittently transfers, via the energy storage element, electrical energy between the first battery and the second battery, the switching circuit including a plurality of switching elements; and a current detector that detects current through the first battery and current through the second battery. The drive measurement method includes: receiving, from a higher-level system having a function to calculate AC impedance, a measurement instruction signal including information on a measurement frequency; driving the plurality of switching elements to periodically change, in accordance with the measurement frequency, a state of electrical energy transfer via the energy storage element; measuring the current through the first battery and the current through the second battery, based on a detection result obtained by the current detector; measuring voltage of the first battery and voltage of the second battery; and measuring AC voltage and AC current corresponding to the measurement frequency, based on a measurement result obtained in the measuring of the voltage and a measurement result obtained in the measuring of the current, and outputting the AC voltage measured and the AC current measured to the higher-level system.

### [Advantageous Effects of Invention]

According to a drive measurement circuit, for instance, according to an aspect of the present disclosure, an impedance measurement device can be miniaturized.

### [Brief Description of Drawings]

These and other advantages and features will become apparent from the following description thereof taken in conjunction with the accompanying Drawings, by way of non-limiting examples of embodiments disclosed herein.

[FIG. 1]

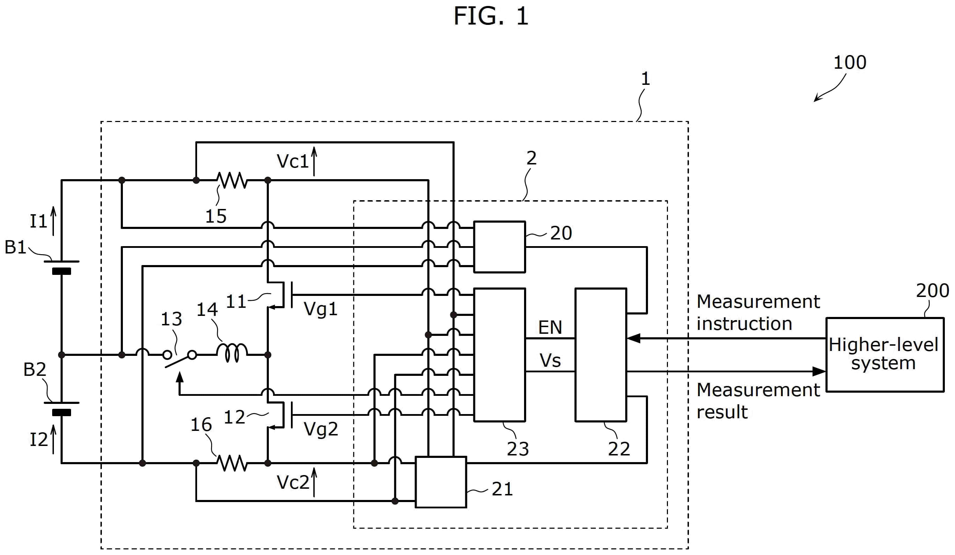

   FIG. 1 is a schematic configuration diagram showing an example of an impedance measurement system according to Embodiment 1.
[FIG. 2]

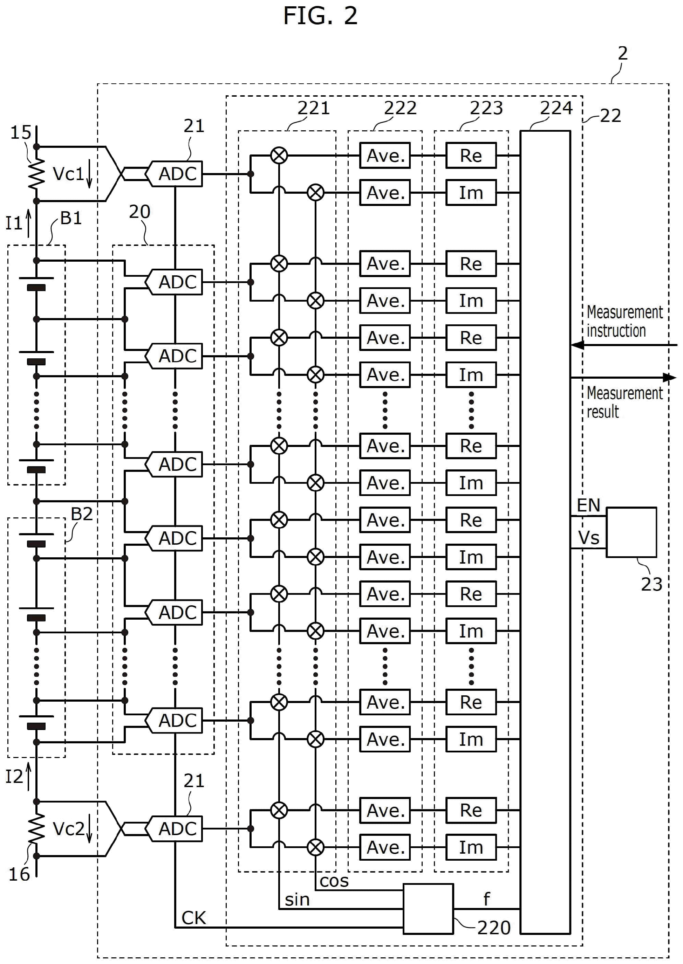

   FIG. 2 is a circuit configuration diagram showing examples of a voltage measurer, a current measurer, and an AC detector of an impedance measurement device according to Embodiment 1.
[FIG. 3]

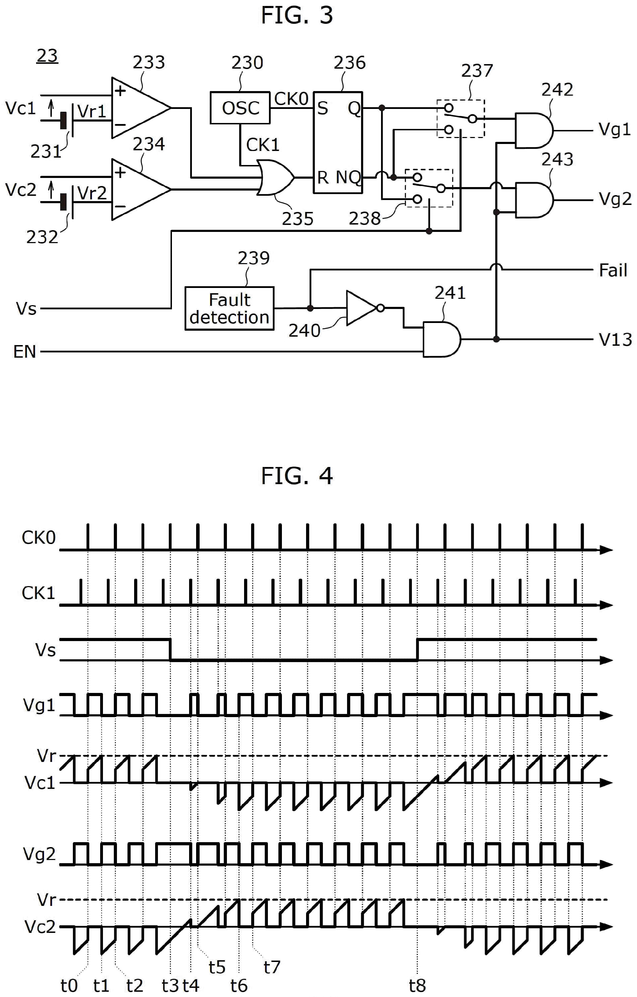

   FIG. 3 is a circuit configuration diagram showing an example of a drive controller of the impedance measurement device according to Embodiment 1.
[FIG. 4]
   FIG. 4 is a timing chart showing an example of the operation of the impedance measurement device according to Embodiment 1.
[FIG. 5]

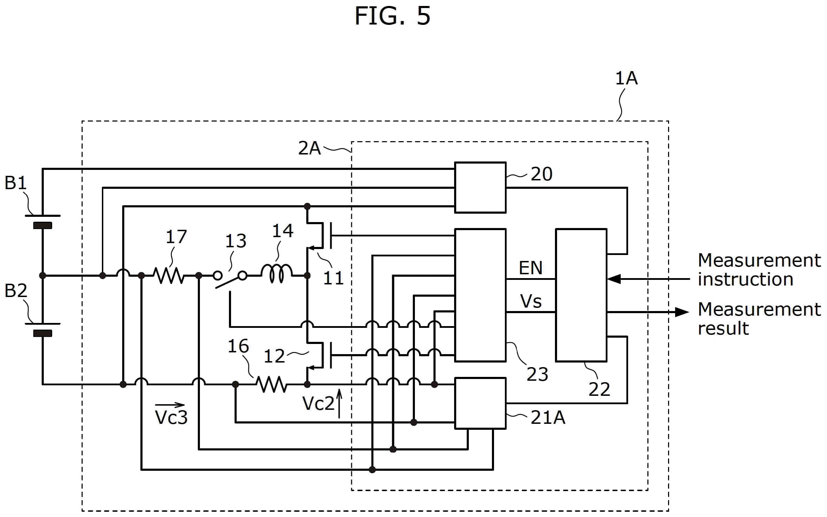

   FIG. 5 is a schematic configuration diagram showing an example of an impedance measurement device according to Embodiment 2.
[FIG. 6]

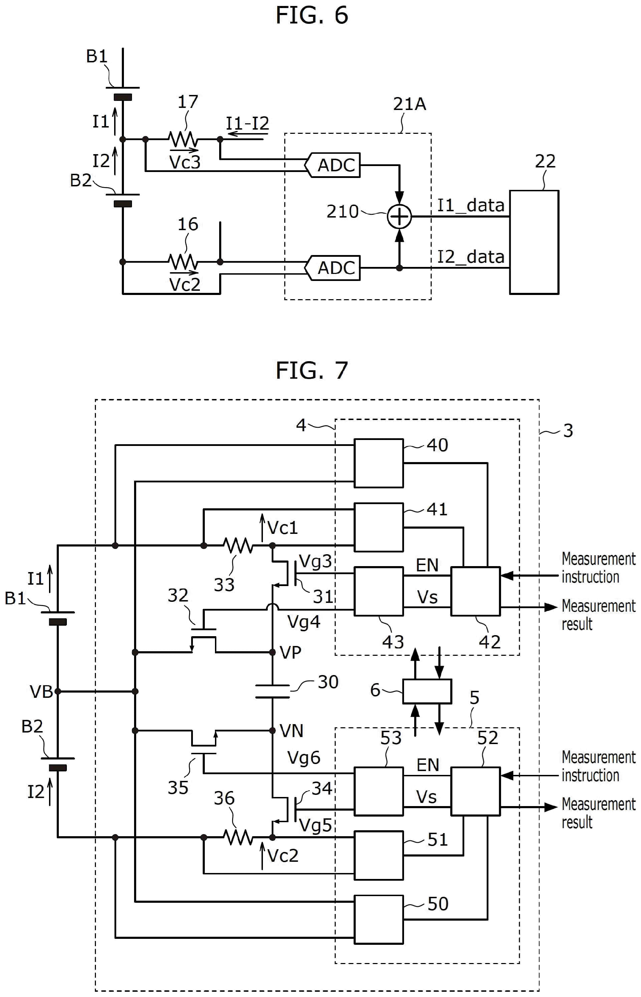

   FIG. 6 is a configuration diagram showing an example of a current measurer of the impedance measurement device according to Embodiment 2.
[FIG. 7]
   FIG. 7 is a schematic configuration diagram showing an example of an impedance measurement device according to Embodiment 3.
[FIG. 8]

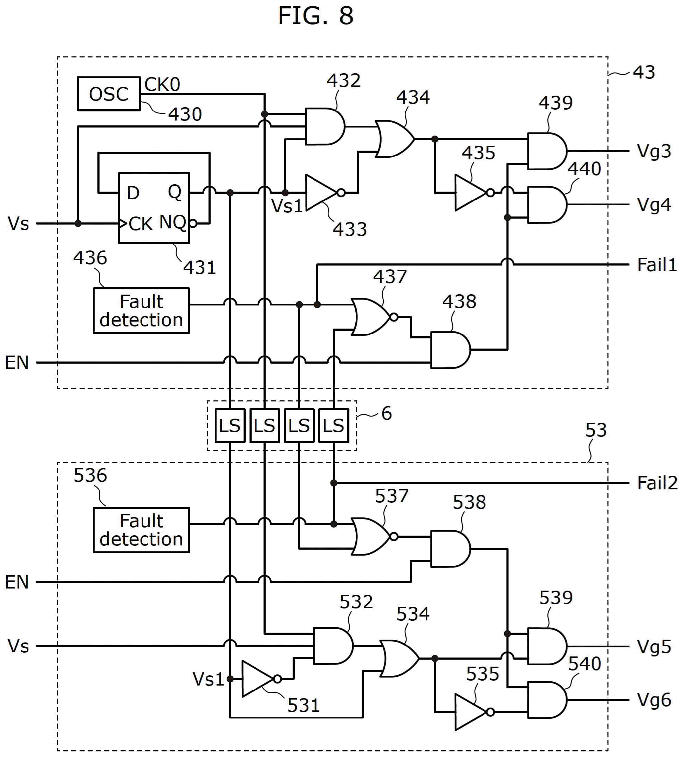

   FIG. 8 is a circuit configuration diagram showing examples of drive controllers of the impedance measurement device according to Embodiment 3.
[FIG. 9]

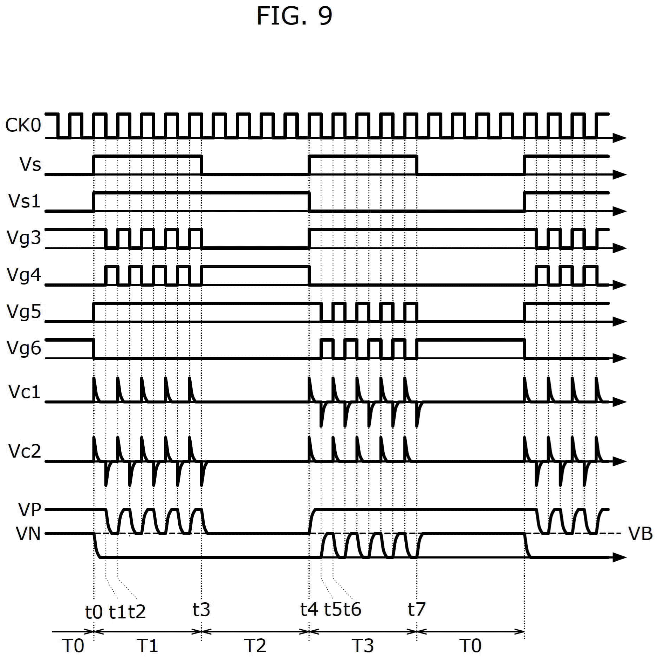

   FIG. 9 is a timing chart showing an example of the operation of the impedance measurement device according to Embodiment 3.
[FIG. 10]

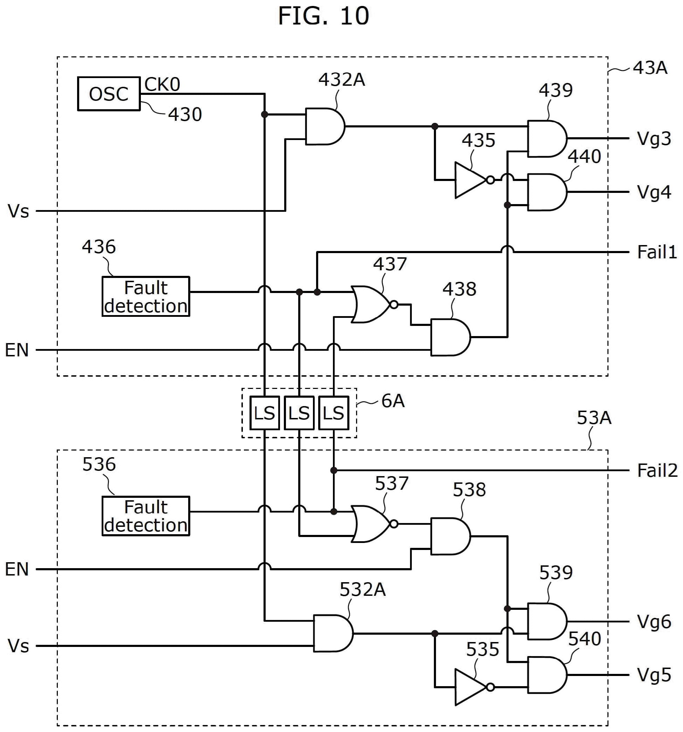

   FIG. 10 is a circuit configuration diagram showing examples of drive controllers of an impedance measurement device according to Embodiment 4.
[FIG. 11]

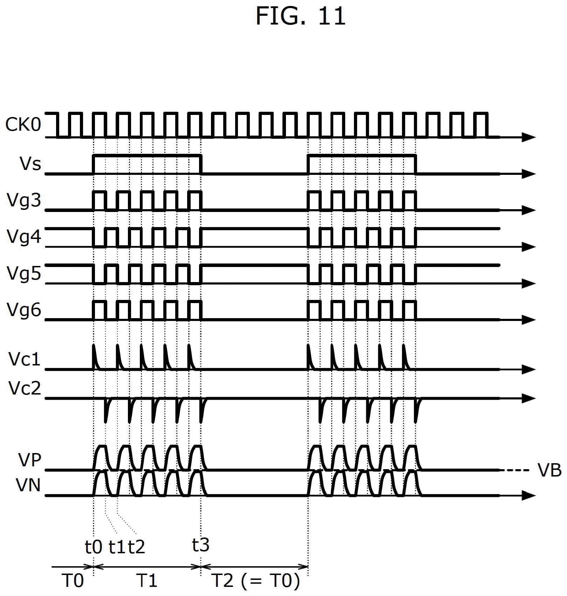

   FIG. 11 is a timing chart illustrating an example of the operation of the impedance measurement device according to Embodiment 4.
[FIG. 12]

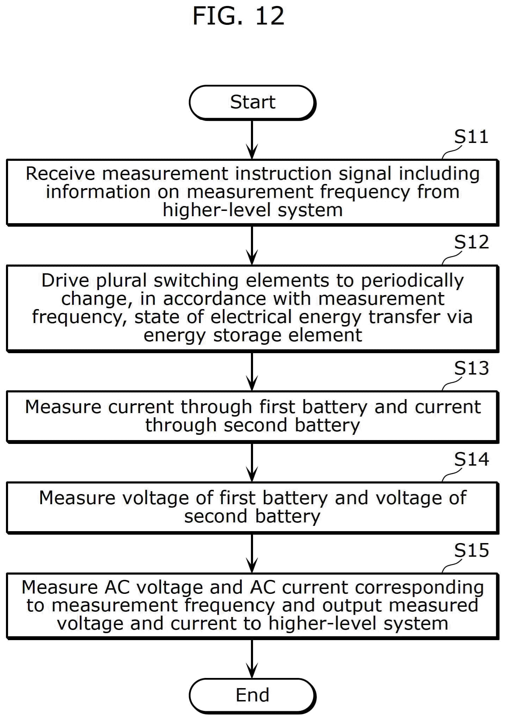

   FIG. 12 is a flowchart showing an example of a drive measurement method according to another embodiment.

### [Description of Embodiments]

In the following, embodiments are to be specifically described with reference to the drawings. Note that the embodiments described below each show a particular example of the present disclosure. The numerical values, shapes, materials, elements, the arrangement and connection of the elements, steps, the processing order of the steps, and others indicated in the following embodiments are examples, and are not intended to limit the present disclosure. In addition, among the elements in the following embodiments, elements not recited in any of the independent claims are described as optional elements.

Note that the drawings are schematic diagrams, and do not necessarily provide strictly accurate illustration. Throughout the drawings, the same numeral is given to substantially the same element, and redundant description is omitted or simplified.

### [Embodiment 1]

FIG. 1 is a schematic configuration diagram showing an example of impedance measurement system 100 according to Embodiment 1. Note that FIG. 1 also shows batteries B1 and B2 in addition to impedance measurement system 100.

Impedance measurement system 100 includes impedance measurement device 1 and higher-level system 200. Impedance measurement device 1 measures alternating-current (AC) impedance of each of battery B1 and battery B2 that are connected in series. Battery B1 is an example of a first battery, and battery B2 is an example of a second battery. For example, batteries B1 and B2 are rechargeable secondary batteries such as lithium-ion batteries, with battery B1 being placed on the higher-potential side relative to battery B2. Higher-level system 200 is a system having a function of calculating the AC impedance.

Impedance measurement device 1 includes: an energy storage element that stores or releases electrical energy; a switching circuit that includes a plurality of switching elements and intermittently transfers electrical energy between battery B1 and battery B2 via the energy storage element; a current detector that detects current through battery B1 and current through battery B2; and drive measurement circuit 2. Note that impedance measurement device 1 may not include drive measurement circuit 2, and impedance measurement device 1 and drive measurement circuit 2 may be provided separately. The same applies to Embodiments 2 through 4 described below, and the impedance measurement device and the drive measurement circuit may be provided separately.

In Embodiment 1, the energy storage element is inductor 14. In Embodiment 1, the switching circuit includes first switching element 11 that forms a first loop with battery B1 and inductor 14, and second switching element 12 that forms a second loop with battery B2 and inductor 14. For example, the switching circuit includes current interrupter 13 connected in series with inductor 14. For example, the current detector includes detection resistor 15 connected between battery B1 and first switching element 11 and detection resistor 16 connected between battery B2 and second switching element 12. Detection resistor 15 is an example of a first detection resistor, and detection resistor 16 is an example of a second detection resistor. The current through battery B1 can be detected by detecting the current flowing through detection resistor 15, and the current through battery B2 can be detected by detecting the current flowing through detection resistor 16.

First switching element 11 and second switching element 12 are, for example, N-channel metal oxide semiconductor field effect transistors (MOSFETs). The drain of first switching element 11 is connected to the positive electrode of battery B1, the source of first switching element 11 is connected to the drain of second switching element 12, and the source of second switching element 12 is connected to the negative electrode of battery B2. A series circuit of current interrupter 13 and inductor 14 is connected between the connection point between battery B1 and battery B2 and the connection point between first switching element 11 and second switching element 12. For example, detection resistor 15 is connected between the positive electrode of battery B1 and the drain of first switching element 11 to detect charge/discharge current I1 of battery B1. For example, detection resistor 16 is connected between the negative electrode of battery B2 and the source of second switching element 12 to detect charge/discharge current I2 of battery B2.

Note that first switching element 11 and second switching element 12 become conductive when a voltage is applied to their control terminals (gates), and allow current in the reverse direction (opposite to the directions of the arrows representing currents I1 and I2 shown in FIG. 1) to flow using, for example, body diodes. First switching element 11 and second switching element 12 are represented by field-effect transistors as an example. Current interrupter 13 conducts and interrupts bidirectional current, and thus a configuration of two field-effect transistors connected face-to-face is typically employed. However, since the figure would become complicated, it is represented by a switch circuit symbol.

Drive measurement circuit 2 is a circuit for controlling impedance measurement device 1 (more specifically, the switching circuit included in impedance measurement device 1), and includes voltage measurer 20, current measurer 21, AC detector 22, and drive controller 23.

Voltage measurer 20 measures the voltage of battery B1 and the voltage of battery B2. Current measurer 21 measures the current through battery B1 and the current through battery B2, based on the detection result obtained by the current detector. Specifically, current measurer 21 measures current I1 flowing through battery B1 from detection voltage Vc1 obtained by detection resistor 15, and measures current I2 flowing through battery B2 from detection voltage Vc2 obtained by detection resistor 16.

AC detector 22 receives, from higher-level system 200, a measurement instruction signal that includes information on the measurement frequency, and conveys enable signal EN and control signal Vs to drive controller 23 in accordance with the measurement instruction signal. AC detector 22 also conveys, to higher-level system 200, information for calculating the AC impedance (voltage information from voltage measurer 20 and current information from current measurer 21). Details of AC detector 22 will be described later.

Drive controller 23 drives first switching element 11 and second switching element 12, based on enable signal EN and control signal Vs from AC detector 22. Details of drive controller 23 will be described later.

Note that higher-level system 200 may have calculation functionality similar to the one that a CPU has, and may be a microcontroller unit (MCU) or an electronic control unit (ECU), for example.

Next, details of the configuration of AC detector 22 will be described.

FIG. 2 is a circuit configuration diagram showing an example of voltage measurer 20, current measurer 21, and AC detector 22 of impedance measurement device 1 according to Embodiment 1. FIG. 2 mainly shows the internal configurations of voltage measurer 20, current measurer 21, and AC detector 22. FIG. 2 shows that batteries B1 and B2 are each configured of a plurality of cells connected in series, and voltage measurer 20 is configured to measure the voltages of the individual battery cells. Both voltage measurer 20 and current measurer 21 include analog-to-digital converters (hereinafter abbreviated as ADCs) that convert detected voltages into digital signals, and voltage information from voltage measurer 20 and current information from current measurer 21 are conveyed to AC detector 22 as digital values. The ADCs measure voltages of and currents through batteries B1 and B2 at the sampling frequency of clock signal CK described later.

As shown in FIG. 2, AC detector 22 includes signal generator 220, converter 221, integrator 222, holder 223, and communicator 224, for example.

Signal generator 220 outputs a first reference-frequency signal with frequency f specified by a measurement command from higher-level system 200, a second reference-frequency signal having a phase orthogonal to the first reference-frequency signal, and clock signal CK to the ADCs of voltage measurer 20 and current measurer 21. The first reference-frequency signal is sine wave sin, and the second reference-frequency signal is cosine wave cos. Clock signal CK is a signal with a frequency higher than the first reference frequency signal and synchronized with the first reference frequency signal.

Converter 221 includes pairs of multipliers corresponding to the ADCs, and each of the multiplier pairs multiplies a digital value from the corresponding ADC by first reference-frequency signal sin and second reference-frequency signal cos, thereby converting the digital value into real components and imaginary components of the complex voltage and the complex current. The multiplication result with first reference-frequency signal sin indicates the real component when the sampled voltage is expressed as a complex voltage. The multiplication result with second reference-frequency signal cos indicates the imaginary component when the sampled voltage is expressed as a complex voltage.

Integrator 222 includes averaging-circuit pairs corresponding in number to the multiplier pairs of converter 221, and averages the real and imaginary components of the complex voltage and the complex current repeatedly measured, which result from conversion by converter 221. This averaging reduces errors in measuring the complex voltage and the complex current and can improve resolution (measurement accuracy) by oversampling. Accordingly, even with ADCs having a small number of bits (for example about 16 bits), it is possible to obtain AC impedance measurement results with an accuracy of about 20 bits to 24 bits.

Holder 223 holds the real and imaginary components of the complex voltage and complex current, which result from averaging processing. Each register pair for holding a complex voltage includes register Re that holds the real components of the complex voltage and the complex current of the corresponding battery cell and register Im that holds the imaginary components thereof.

Communicator 224 is a communication circuit for communicating with higher-level system 200. Communicator 224 is used to transmit data stored in holder 223 to higher-level system 200, and to receive measurement instruction signals from higher-level system 200 (operation commands to drive controller 23 and information on frequency f of the first reference-frequency signal). Communication performed by communicator 224 may be wireless or wired, and is not limited to any particular communication standard.

Next, details of the configuration of drive controller 23 are described.

FIG. 3 is a circuit configuration diagram showing an example of drive controller 23 of impedance measurement device 1 according to Embodiment 1. FIG. 3 illustrates an internal configuration of drive controller 23.

As shown in FIG. 3, oscillator 230 outputs reference clock CK0 that sets the switching period and clock CK1 that is delayed from reference clock CK0 by the maximum on-time of first switching element 11 and second switching element 12. Embodiment 1 shows an example in which oscillator 230 of drive controller 23 generates these clock signals, but these clock signals may instead be received from higher-level system 200 or the like, clock signal CK of AC detector 22 may be used, or these clock signals may be synchronized with clock signal CK.

Reference voltage source 231 generates threshold voltage Vr1, and reference voltage source 232 generates threshold voltage Vr2. Comparator 233 compares detection voltage Vc1 with threshold voltage Vr1, and comparator 234 compares detection voltage Vc2 with reference voltage Vr2. The present disclosure shows an example in which these threshold voltages are generated inside drive controller 23, but these threshold voltages may be supplied from higher-level system 200 or the like or as described below, may be made variable under the instruction from higher-level system 200.

Clock CK1 and the outputs of comparator 233 and comparator 234 are input to OR circuit 235. Reference clock CK0 sets SR latch 236, and the output of OR circuit 235 resets SR latch 236. Outputs Q and NQ of SR latch 236 are input to switch circuits 237 and 238. Control signal Vs from AC detector 22 is a signal whose high and low states are switched based on the phase of the first reference-frequency signal. Since the first reference-frequency signal is a signal with the measurement frequency (frequency f) specified by the measurement instruction from higher-level system 200, control signal Vs is a signal with frequency f. When control signal Vs is at the H level, switch circuit 237 selects and outputs output Q of SR latch 236, and switch circuit 238 selects and outputs output NQ. When control signal Vs is at the L level, switch circuit 237 selects and outputs output NQ of SR latch 236, and switch circuit 238 selects and outputs output Q. The output of switch circuit 237 is a signal that drives first switching element 11, and the output of switch circuit 238 is a signal that drives second switching element 12.

Since abnormality detection circuit 239 is not essential to the present application, detailed description and illustration are omitted. However, abnormality detection circuit 239 outputs H-level abnormality signal Fail when any of, for instance, the current or voltage values of the batteries detected by AC detector 22 and the temperatures of the batteries detected by temperature sensors not shown indicates an abnormal value. Abnormality signal Fail is logically inverted by inverter 240 and is input to AND circuit 241 together with enable signal EN. The output of AND circuit 241 is drive signal V13 for current interrupter 13. When drive signal V13 is at the H level, current interrupter 13 becomes conductive, whereas when drive signal V13 is at the L level, current interrupter 13 interrupts current. The output of switch circuit 237 and drive signal V13 are input to AND circuit 242, and AND circuit 242 outputs drive signal Vg1. The output of switch circuit 238 and drive signal V13 are input to AND circuit 243, and AND circuit 243 outputs drive signal Vg2. That is, if no abnormality is present and a measurement instruction is received from higher-level system 200, drive signal V13 causes current interrupter 13 to conduct, electrically connecting inductor 14 to first switching element 11 and second switching element 12, and first switching element 11 and second switching element 12 are driven on and off alternately.

Note that, to prevent first switching element 11 and second switching element 12 from being simultaneously placed in the ON state, a dead time during which drive signals Vg1 and Vg2 are simultaneously off is normally provided. Although not shown, a delay time corresponding to the dead time is provided on the rising edge of each drive signal, herein.

Next, details of the operation of drive controller 23 are described.

FIG. 4 is a timing chart illustrating an example of the operation of impedance measurement device 1 according to Embodiment 1. FIG. 4 is a timing chart showing the operation of main portions of drive controller 23, and shows reference clock CK0, clock CK1, control signal Vs, drive signal Vg1, detection voltage Vc1, drive signal Vg2, and detection voltage Vc2. Although not shown, enable signal EN is at the H level and abnormality signal Fail is at an L level. Detection voltage Vc1 corresponds to current I1 flowing through battery B1 and first switching element 11, and detection voltage Vc2 corresponds to current I2 flowing through battery B2 and second switching element 12. For example, threshold voltages Vr1 and Vr2 may be the same voltage, and in FIG. 4, threshold voltages Vr1 and Vr2 are each indicated as threshold voltage Vr. In the following, operation in which high-frequency current pulses are caused to flow through batteries B1 and B2 with high efficiency by drive controller 23 of impedance measurement device 1 according to Embodiment 1 will be described with reference to FIG. 4.

First, as shown on the left side of FIG. 4, the operation of drive controller 23 from time t0 to time t2 when control signal Vs is at the H level will be described. Since control signal Vs is at the H level from time t0 to time t2, output Q of SR latch 236 is output as drive signal Vg1 for first switching element 11, and output NQ of SR latch 236 is output as drive signal Vg2 for second switching element 12.

At time t0, when reference clock CK0 rises, SR latch 236 is set, output Q, that is, drive signal Vg1 rises and output NQ, that is, drive signal Vg2 falls. Drive signal Vg1 turns first switching element 11 on and first switching element 11 becomes conductive, so current I1 flows through a first loop from the positive electrode of battery B1 to the negative electrode of battery B1 via first switching element 11, inductor 14 and current interrupter 13. On the other hand, drive signal Vg2 goes to the L level so second switching element 12 is turned off, current I2 does not flow, and detection voltage Vc2 also becomes zero. Current I1 increases with a slope determined by the voltage of battery B1 and the inductance of inductor 14, and detection voltage Vc1 increases proportionally to current I1.

At time t1, when detection voltage Vc1 reaches threshold voltage Vr1, the output of comparator 233 inverts and goes to the H level, and resets SR latch 236 via OR circuit 235. Resetting SR latch 236 causes output Q, that is, drive signal Vg1 to fall and output NQ, that is, drive signal Vg2 to rise. First switching element 11 turns off and the voltage across inductor 14 is inverted. The body diode of second switching element 12 becomes conductive, and second switching element 12 enters the ON state after the dead time. Note that since the dead time is very brief, it is not shown in the figure, so that the conduction of the body diode of second switching element 12 and the turn-on of second switching element 12 are represented as occurring simultaneously at time t1. The current in inductor 14 is maintained, and current I2 flows through the second loop from the negative electrode of battery B2 to the positive electrode of battery B2 via second switching element 12, inductor 14, and current interrupter 13. This is a negative current opposite in direction to current I2 indicated in the figure. With a current value whose absolute value corresponds to threshold voltage Vr1 as an initial value, the current increases in the positive direction with a slope determined by the voltage of battery B2 and the inductance of inductor 14.

Eventually, when time t2 is reached, reference clock CK0 rises and the operation from time t0 is repeated. By this repetition, pulsed currents flow: for battery B1, current I1 in the discharge direction flows as pulses peaking at the current value corresponding to threshold voltage Vr1; and for battery B2, current I2 in the charging direction flows as pulses peaking at the current value corresponding to threshold voltage Vr1.

Next, at time t3, when control signal Vs goes to the L level, switch circuit 237 switches to select and output output NQ of SR latch 236, and switch circuit 238 switches to select and output output Q of SR latch 236. Accordingly, after that, the timing at which drive signals Vg1 and Vg2 rise is switched. Specifically, drive signal Vg2 goes to the H level at the rising of reference clock CK0, and goes to the L level when detection voltage Vc2 reaches threshold voltage Vr2 or when clock CK1 rises. From time t3 onward, a state in which current I2 flows continues, and current I2 increases.

At time t4, when the ON state of second switching element 12 reaches its maximum on-time, clock CK1 rises, and SR latch 236 is reset via OR circuit 235, drive signal Vg2 falls, and second switching element 12 turns off. At this time, if increasing current I2 has reached the positive direction, the voltage across inductor 14 is inverted. The body diode of first switching element 11 becomes conductive, and first switching element 11 enters the ON state after the dead time.

When time t5 is reached, reference clock CK0 rises, SR latch 236 is set, so output Q, that is, drive signal Vg2 rises, and output NQ, that is, drive signal Vg1 falls. Drive signal Vg2 turns second switching element 12 on and second switching element 12 becomes conductive, and current I2 flows through the second loop from the positive electrode of battery B2 to the negative electrode of battery B2 through current interrupter 13, inductor 14, and second switching element 12. Meanwhile, drive signal Vg1 goes to the L level so first switching element 11 is turned off, current I1 does not flow, and detection voltage Vc1 also becomes zero. Current I2 increases with a slope determined by the voltage of battery B2 and the inductance of inductor 14, and detection voltage Vc2 increases proportionally to current I2. Thereafter, the operation from time t3, in which second switching element 12 performs switching operation at the maximum on-time, is repeated. By this repetition, the peak value of current I2 increases.

At time t6, when detection voltage Vc2 of current I2 reaches threshold voltage Vr2, the output of comparator 234 inverts and goes to the H level and resets SR latch 236 via OR circuit 235. Resetting SR latch 236 causes output Q, that is, drive signal Vg2 to fall and output NQ, that is, drive signal Vg1 to rise. Second switching element 12 turns off and the voltage across inductor 14 is inverted. The body diode of first switching element 11 becomes conductive, and first switching element 11 enters the ON state after the dead time. The current through inductor 14 is maintained, and current I1 flows through a first loop from the negative electrode of battery B1 to the positive electrode of battery B1, via current interrupter 13, inductor 14, and first switching element 11. This is a negative current opposite in direction to current I1 indicated in the figure. With a current value whose absolute value corresponds to threshold voltage Vr2 as an initial value, the current increases in the positive direction with a slope determined by the voltage of battery B1 and the inductance of inductor 14.

Eventually, when time t7 is reached, reference clock CK0 rises and the operation from time t5 is repeated. By this repetition, pulsed currents flow: for battery B2, current I2 in the discharge direction flows as pulses peaking at the current value corresponding to threshold voltage Vr2; and for battery B1, current I1 in the charging direction flows as pulses peaking at the current value corresponding to threshold voltage Vr2.

Next, at time t8, when control signal Vs goes to the H level, switch circuit 237 switches to select and output output Q of SR latch 236, and switch circuit 238 switches to select and output output NQ of SR latch 236. Accordingly, after that, the timing at which drive signals Vg1 and Vg2 rise is also switched. Specifically, drive signal Vg1 goes to the H level at the rising of reference clock CK0, and goes to the L level when detection voltage Vc2 reaches threshold voltage Vr2 or when clock CK1 rises. From time t8 onward, a state in which current I1 flows continues, and current I1 increases.

Thereafter, due to the switching operation of first switching element 11 at the maximum on-time, current I1 increases and current I2 decreases, and eventually the peak value of current I1 reaches the current value corresponding to threshold voltage Vr1, after which the operation from time t0 onward is performed again.

As described above, in accordance with control signal Vs, charge and discharge of battery B1 and battery B2 are repeatedly performed with pulse currents of predetermined peak values with low loss. Current I1, which is the charge-discharge current, is converted by detection resistor 15 into detection voltage Vc1, and current I2 is converted by detection resistor 16 into detection voltage Vc2, which are input to current measurer 21. While measuring the AC impedance, in the H-level period of control signal Vs, impedance measurement device 1 regenerates the energy drawn from battery B1 to battery B2, whereas in the L-level period of control signal Vs, impedance measurement device 1 regenerates the energy drawn from battery B2 to battery B1. Thus, if the H-level period and the L-level period of control signal Vs are equal and threshold voltage Vr1 and threshold voltage Vr2 are equal, the charge-discharge charges of battery B1 and battery B2 are also equal, so that increases and decreases in battery voltage and changes in charge capacity state of charge (SOC) can be inhibited.

Conversely, by making threshold voltage Vr1 different from threshold voltage Vr2, or by changing the high-to-low period ratio of control signal Vs, energy can be transferred from battery B1 to battery B2 or from battery B2 to battery B1. For example, when transferring energy from battery B1 to battery B2, threshold voltage Vr1 may be made higher than threshold voltage Vr2, or the H-level period of control signal Vs may be made longer than the L-level period. Although not essential to the gist of the present disclosure, since the voltages of the batteries are also monitored, this energy transfer can also be applied to maintaining voltage balance between the batteries.

As described above, AC detector 22 receives, from higher-level system 200 having a function to calculate AC impedance, a measurement instruction signal including information on a measurement frequency, measures AC voltage and AC current corresponding to the measurement frequency, based on a measurement result obtained by voltage measurer 20 and a measurement result obtained by current measurer 21, and outputs the AC voltage measured and the AC current measured to higher-level system 200. Drive controller 23 drives the plurality of switching elements (here, first switching element 11 and second switching element 12) to periodically change, in accordance with the measurement frequency, a state of electrical energy transfer via inductor 14.

Accordingly, since the state of electrical energy transfer between battery B1 and battery B2 is periodically changed according to the measurement frequency, AC voltage and AC current corresponding to the measurement frequency can be measured, and the AC impedance of batteries B1 and B2 can be measured. At this time, the state of electrical energy transfer can be changed via single inductor 14 provided in impedance measurement device 1, so that unlike the method disclosed in PTL 2, both an inductor and an energy storage device (capacitor) are not required. Thus, impedance measurement device 1 can be miniaturized. In other words, the AC impedances of series-connected batteries B1 and B2 can be appropriately obtained with a small number of components.

In the method disclosed in PTL 2, the energy storage device may be a battery, but there is a constraint that the device is at a lower potential than a non-measured battery. In contrast, since drive measurement circuit 2 can measure AC impedance regardless of the relative magnitudes of the voltage of battery B1 and the voltage of battery B2, usage constraints can be relaxed.

In the method disclosed in PTL 2, there is a problem that, in order to prevent a decrease in the battery's state of charge (SOC), time is required after measurement to regenerate the energy charged into the energy storage device during measurement back to the battery. In contrast, since drive measurement circuit 2 continuously generates intermittent currents during measurement without providing rest periods, the measurement time can be shortened.

Note that as shown in FIG. 2, each of battery B1 and battery B2 may include two or more battery cells, and voltage measurer 20 may simultaneously measure the voltages of the two or more battery cells. Accordingly, the voltages of battery B1 and battery B2 can be measured in a short time.

Also, as shown in FIG. 4, drive controller 23 may alternately place first switching element 11 and second switching element 12 into the ON state at a frequency higher than the measurement frequency. This can shorten the time during which current flows to inductor 14 at one time. In other words, because a large current is less likely to flow through inductor 14, inductor 14 can be miniaturized, and consequently impedance measurement device 1 can be miniaturized.

Drive controller 23 may control the on-times of first switching element 11 and second switching element 12 so as to repeat, at a cycle corresponding to the measurement frequency, a first energy transfer state (from time t0 to time t4 in FIG. 4) in which flowing discharge current from battery B1 when first switching element 11 is on and flowing charge current into battery B2 when second switching element 12 is on are repeated, and a second energy transfer state (from time t4 to time t8 in FIG. 4) in which flowing discharge current from battery B2 when second switching element 12 is on and flowing charge current into battery B1 when first switching element 11 is on are repeated.

Accordingly, as from time t3 to time t4 in FIG. 4, discharge current can be caused to start flowing from battery B2 by lengthening the on-time of second switching element 12, and as a result, it is possible to switch from the first energy transfer state to the second energy transfer state. Also, as after time t8 in FIG. 4, discharge current can be caused to start flowing from battery B1 by lengthening the on-time of first switching element 11, and as a result, it is possible to switch from the second energy transfer state to the first energy transfer state.

Drive controller 23 may limit the peak value of the discharge current from battery B1 to a predetermined value (a value corresponding to threshold voltage Vr1) in the first energy transfer state, and may limit the peak value of the discharge current from battery B2 to a predetermined value (a value corresponding to threshold voltage Vr2) in the second energy transfer state. By doing so, the discharge current from battery B1 and the discharge current from battery B2 can be limited, thereby inhibiting switching losses that occur during switching.

The switching circuit may include current-interrupter 13 connected in series with inductor 14, and drive controller 23 may interrupt the current flowing through current interrupter 13 when the detection results obtained using detection resistors 15 and 16 each exceed a predetermined amount. Accordingly, the current can be interrupted when overcurrent flows.

### [Embodiment 2]

Next, Embodiment 2 will be described. In Embodiment 2, the current detector includes one of detection resistor 15 connected between battery B1 and first switching element 11 or detection resistor 16 connected between battery B2 and second switching element 12, and detection resistor 17 connected in series with inductor 14. Below, an example in which the current detector includes detection resistors 16 and 17 will be described.

FIG. 5 is a schematic configuration diagram showing an example of impedance measurement device 1A according to Embodiment 2. Note that FIG. 5 also shows batteries B1 and B2 in addition to impedance measurement device 1A. In FIG. 5, elements having an equivalent configuration to those shown in FIG. 1 are assigned the same reference numerals, and their descriptions are omitted or simplified. The configuration differing from impedance measurement device 1 shown in FIG. 1 is the configuration for detecting current through battery B1. Instead of detection resistor 15 in FIG. 1, detection resistor 17 is inserted in series to current interrupter 13 and inductor 14, and current I3 flowing through detection resistor 17 is detected. The voltage across detection resistor 17 is denoted as detection voltage Vc3, and detection voltage Vc3 is input to and processed by current measurer 21A.

FIG. 6 is a configuration diagram showing an example of current measurer 21A of impedance measurement device 1A according to Embodiment 2. Note that in addition to current measurer 21A, FIG. 6 also shows peripheral circuits of current measurer 21A. Current measurer 21A additionally includes adder 210 as compared with current measurer 21 in FIG. 2, and outputs the sum of the outputs of the ADC that digitizes detection voltage Vc2 and the ADC that digitizes detection voltage Vc3, as detection data of current I1. Since current I3 flowing through detection resistor 17 is a difference between current I1 and current I2 (that is, I3 = I1 - I2), similarly to Embodiment 1 shown in FIG. 1, the sum of currents I2 and I3 (that is, I1 = I2 + I3) may be calculated in order to detect current I1.

As described above, in Embodiment 2, the position of the detection resistor is changed from the configuration in Embodiment 1, and the associated signal processing is also changed. Compared with the case in Embodiment 1 where detection resistor 15 is connected to a high potential such as the positive electrode of battery B1, since the detection resistor is connected to the battery midpoint, the level shifting circuit is readily configured and the detection accuracy is improved. Note that although not shown, detection resistor 15 may be provided instead of detection resistor 16. In other words, detection resistor 15 may be connected to a high potential such as the positive electrode of battery B1.

Note that the device can be further miniaturized and generalized by integrating part or the entirety of drive measurement circuit 2 according to Embodiment 1 or part or the entirety of drive measurement circuit 2A according to Embodiment 2 into an integrated circuit.

### [Embodiment 3]

In Embodiments 1 and 2, examples were described in which an energy storage element that stores or releases electrical energy is inductor 14, whereas in Embodiment 3, an example is described in which the energy storage element is a capacitor.

FIG. 7 is a schematic configuration diagram showing an example of impedance measurement device 3 according to Embodiment 3. Note that FIG. 7 also shows batteries B1 and B2 in addition to impedance measurement device 3. Impedance measurement device 3 measures alternating-current (AC) impedance of battery B1 and battery B2 that are connected in series.

Impedance measurement device 3 includes: an energy storage element that stores or releases electrical energy; a switching circuit that includes a plurality of switching elements and intermittently transfers electrical energy between battery B1 and battery B2 via the energy storage element; a current detector that detects current through battery B1 and current through battery B2; and drive measurement circuits 4 and 5.

In Embodiment 3, the energy storage element is capacitor 30. In Embodiment 3, the switching circuit includes third switching element 31 connected between the positive electrode of battery B1 and the positive electrode of capacitor 30, and fourth switching element 32 connected between the negative electrode of battery B1 and the positive electrode of capacitor 30. The switching circuit also includes fifth switching element 34 connected between the negative electrode of battery B2 and the negative electrode of capacitor 30, and sixth switching element 35 connected between the positive electrode of battery B2 and the negative electrode of capacitor 30.

For example, the current detector includes detection resistor 33 connected between battery B1 and third switching element 31 and detection resistor 36 connected between battery B2 and fifth switching element 34. Detection resistor 33 is an example of a first detection resistor, and detection resistor 36 is an example of a second detection resistor. The current through battery B1 can be detected by detecting the current flowing through detection resistor 33, and the current through battery B2 can be detected by detecting the current flowing through detection resistor 36. Current I1 flowing through battery B1 is converted by detection resistor 33 into detection voltage Vc1, and current I2 flowing through battery B2 is converted by detection resistor 36 into detection voltage Vc2.

Third switching element 31, fourth switching element 32, fifth switching element 34, and sixth switching element 35 are N-channel MOSFETs, for example. The drain of third switching element 31 is connected to the positive electrode of battery B1, and the source of third switching element 31 is connected to the positive electrode of capacitor 30. The drain of fourth switching element 32 is connected to the positive electrode of capacitor 30, and the source of fourth switching element 32 is connected to the negative electrode of battery B1. The drain of fifth switching element 34 is connected to the negative electrode of capacitor 30, and the source of fifth switching element 34 is connected to the negative electrode of battery B2. The drain of sixth switching element 35 is connected to the positive electrode of battery B2, and the source of sixth switching element 35 is connected to the negative electrode of capacitor 30.

In response to a measurement instruction signal from higher-level system 200, drive measurement circuit 4 outputs drive signal Vg3 for third switching element 31 and drive signal Vg4 for fourth switching element 32, receives the voltage of battery B1 and current detection signal Vc1, and transmits the measurement result to higher-level system 200. Similarly, in response to a measurement instruction signal from higher-level system 200, drive measurement circuit 5 outputs drive signal Vg5 for fifth switching element 34 and drive signal Vg6 for sixth switching element 35, receives the voltage of battery B2 and current detection signal Vc2, and transmits the measurement result to higher-level system 200.

Note that third switching element 31, fourth switching element 32, fifth switching element 34, and sixth switching element 35 become conductive when a voltage is applied to their control terminals (gates) and allow current in the reverse direction (opposite to the directions of the arrows representing currents I1 and I2 shown in FIG. 7) to flow using, for example, body diodes. The switching elements are represented as field-effect transistors as an example.

Drive measurement circuit 4 includes voltage measurer 40, current measurer 41, AC detector 42, and drive controller 43. Drive measurement circuit 5 includes voltage measurer 50, current measurer 51, AC detector 52, and drive controller 53.

Voltage measurer 40 measures the voltage of battery B1. Current measurer 41 measures the current through battery B1, based on the detection result obtained by the current detector. Specifically, current measurer 41 measures current I1 flowing through battery B1 from the detection voltage Vc1 obtained by detection resistor 33.

AC detector 42 receives, from higher-level system 200, a measurement instruction signal that includes information on the measurement frequency, and conveys enable signal EN and control signal Vs to drive controller 43 in accordance with the measurement instruction signal. At the same time, AC detector 42 also conveys, to higher-level system 200, information for calculating the AC impedance of battery B1 (voltage information from voltage measurer 40 and current information from current measurer 41).

Drive controller 43 drives third switching element 31 and fourth switching element 32, based on enable signal EN and control signal Vs from AC detector 42. Details of drive controller 43 will be described later.

Voltage measurer 50 measures the voltage of battery B2. Current measurer 51 measures the current through battery B2, based on the detection result obtained by the current detector. Specifically, current measurer 51 measures current I2 flowing through battery B2 from detection voltage Vc2 obtained by detection resistor 36.

AC detector 52 receives, from higher-level system 200, a measurement instruction signal that includes information on the measurement frequency, and conveys enable signal EN and control signal Vs to drive controller 53 in accordance with the measurement instruction signal. At the same time, AC detector 52 also conveys, to higher-level system 200, information for calculating the AC impedance of battery B2 (voltage information from voltage measurer 50 and current information from current measurer 51).

Drive controller 53 drives fifth switching element 34 and sixth switching element 35, based on enable signal EN and control signal Vs from AC detector 52. Details of drive controller 53 will be described later.

Drive measurement circuit 4 and drive measurement circuit 5 transmit to each other and share clock signals and abnormality signals, for instance, which are to be described later, via communicator 6.

Voltage measurer 40 of drive measurement circuit 4 and voltage measurer 50 of drive measurement circuit 5 have the same configuration as that of voltage measurer 20 shown in FIG. 2, current measurer 41 of drive measurement circuit 4 and current measurer 51 of drive measurement circuit 5 have the same configuration as that of current measurer 21 shown in FIG. 2, and AC detector 42 of drive measurement circuit 4 and AC detector 52 of drive measurement circuit 5 have the same configuration as that of AC detector 22 shown in FIG. 2. Thus, illustration and detailed description thereof are omitted.

FIG. 8 is a circuit configuration diagram showing an example of drive controller 43 and an example of drive controller 53 of impedance measurement device 3 according to Embodiment 3. Note that FIG. 8 also shows a portion of communicator 6. FIG. 8 is an internal configuration diagram showing drive controller 43 of drive measurement circuit 4, drive controller 53 of drive measurement circuit 5, and a part of communicator 6.

As shown by drive controller 43 in FIG. 8, oscillator 430 outputs reference clock CK0 with a duty ratio of 50%, which sets the switching period. In Embodiment 3, an example is shown in which reference clock CK0 is generated by oscillator 430 of drive controller 43, but reference clock CK0 may be received from, for instance, higher-level system 200 or drive measurement circuit 5, clock signal CK of AC detector 42 or AC detector 52 may be used, or reference clock CK0 may be a signal synchronized with clock signal CK.

Frequency divider circuit 431 that includes a D latch divides control signal Vs from higher-level system 200 by two and outputs frequency-divided signal Vs1. Although FIG. 8 shows a configuration in which drive controller 43 (drive measurement circuit 4) includes frequency divider circuit 431, higher-level system 200 or drive measurement circuit 5 may include frequency divider circuit 431.

Reference clock CK0, control signal Vs, and frequency-divided signal Vs1 are input to AND circuit 432. The inverted signal of frequency-divided signal Vs1 obtained via inverter 433 and the output of AND circuit 432 are input to OR circuit 434. The output of OR circuit 434 becomes a signal that drives third switching element 31, and the inverted signal obtained from the output of OR circuit 434 via inverter 435 becomes a signal that drives fourth switching element 32.

Since abnormality detection circuit 436 is not essential to the present application, detailed description and illustration are omitted. However, abnormality detection circuit 436 outputs H-level abnormality signal Fail1 when any of, for instance, the current or voltage value of battery B1 detected by AC detector 42 and the temperature of battery B1 detected by a temperature sensor not shown indicates an abnormal value. Abnormality signal Fail1 is input to AND circuit 438 together with enable signal EN via NOR circuit 437. Also, abnormality signal Fail2 from drive measurement circuit 5, which is to be described later, is input to NOR circuit 437 via a level shifting circuit of communicator 6.

The output of AND circuit 438 and the output of OR circuit 434 are input to AND circuit 439, and drive signal Vg3 is output from AND circuit 439. The output of AND circuit 438 and the output of inverter 435 are input to AND circuit 440, and drive signal Vg4 is output from AND circuit 440. That is, if there is no abnormality (specifically, abnormality signals Fail1 and Fail2 are both at the L level) and a measurement instruction is received from higher-level system 200, then when control signal Vs is at the H level and frequency-divided signal Vs1 is at the H level, third switching element 31 and fourth switching element 32 are alternately driven on and off in accordance with reference clock CK0, when control signal Vs is at the L level and frequency-divided signal Vs1 is at the H level, third switching element 31 is turned off and fourth switching element 32 is placed in the ON state; and when frequency-divided signal Vs1 is at the L level, third switching element 31 is turned on and fourth switching element 32 is placed in the OFF state.

Note that, to prevent third switching element 31 and fourth switching element 32 from being simultaneously placed in the ON state, a dead time during which drive signals Vg3 and Vg4 are simultaneously off is normally provided. Although not shown, a delay time corresponding to the dead time is provided on the rising edge of each drive signal, herein.

As shown in FIG. 8 for drive controller 53, reference clock CK0, control signal Vs, and the inverted signal of frequency-divided signal Vs1 obtained via inverter 531 are input to AND circuit 532. Here, reference clock CK0 and frequency-divided signal Vs1 are obtained from drive measurement circuit 4 via the level shifting circuit of communicator 6, and control signal Vs is input from higher-level system 200. Control signal Vs input to drive measurement circuit 4 and control signal Vs input to drive measurement circuit 5 are signals of the same logic, but it is assumed that one of the signals is level-shifted.

The output of AND circuit 532 and frequency-divided signal Vs1 are input to OR circuit 534. The output of OR circuit 534 becomes a signal that drives fifth switching element 34, and the inverted signal obtained from the output of OR circuit 534 via inverter 535 becomes a signal that drives sixth switching element 35.

Since abnormality detection circuit 536 is not essential to the present application, detailed description and illustration are omitted. However, abnormality detection circuit 536 outputs H-level abnormality signal Fail2 when any of, for instance, the current or voltage value detected by AC detector 52 and the temperature of battery B2 detected by a temperature sensor not shown indicates an abnormal value. Abnormality signal Fail2 is input to AND circuit 538 together with enable signal EN via NOR circuit 537. Also, abnormality signal Fail1 from drive measurement circuit 4 described above is input to NOR circuit 537 via the level shifting circuit of communicator 6.

The output of AND circuit 538 and the output of OR circuit 534 are input to AND circuit 539, and drive signal Vg5 is output from AND circuit 539. The output of AND circuit 538 and the output of inverter 535 are input to AND circuit 540, and drive signal Vg6 is output from AND circuit 540. That is, if there is no abnormality (specifically, abnormality signals Fail1 and Fail2 are both at the L level) and a measurement instruction is received from higher-level system 200, when control signal Vs is at the H level and frequency-divided signal Vs1 is at the L level, fifth switching element 34 and sixth switching element 35 are alternately driven on and off in accordance with reference clock CK0, when control signal Vs is at the L level and frequency-divided signal Vs1 is at the L level, fifth switching element 34 is turned off and sixth switching element 35 is placed in the ON state, and when frequency-divided signal Vs1 is at the H level, fifth switching element 34 is turned on and sixth switching element 35 is placed in the OFF state.

Note that, to prevent fifth switching element 34 and sixth switching element 35 from being simultaneously placed in the ON state, a dead time during which drive signals Vg5 and Vg6 are simultaneously off is normally provided. Although not shown, a delay time corresponding to the dead time is provided on the rising edge of each drive signal, herein.

FIG. 9 is a timing chart illustrating an example of the operation of impedance measurement device 3 according to Embodiment 3. FIG. 9 is a timing chart showing the operation of principal part of drive controller 43 and drive controller 53, and shows reference clock CK0, control signal Vs, frequency-divided signal Vs1, drive signal Vg3, drive signal Vg4, drive signal Vg5, drive signal Vg6, detection voltage Vc1, detection voltage Vc2, and positive electrode potential VP and negative electrode potential VN of capacitor 30. Although not shown, enable signal EN is at the H level and abnormality signal Fail1 and abnormality signal Fail2 are both at the L level. Detection voltage Vc1 corresponds to current I1 flowing through battery B1 and third switching element 31, and detection voltage Vc2 corresponds to current I2 flowing through battery B2 and fifth switching element 34. In the following, operation in which impedance measurement device 3 according to Embodiment 3 causes high-frequency current pulses to flow through batteries B1 and B2 will be described with reference to FIG. 9.

As shown in FIG. 9, during period T0, since both control signal Vs and frequency-divided signal Vs1 are at the L level, the drive signals become such that Vg3 is at the H level, Vg4 is at the L level, Vg5 is at the L level, and Vg6 is at the H level. Third switching element 31 is in the ON state and fourth switching element 32 is in the OFF state, and thus positive electrode potential VP of capacitor 30 is fixed to the positive electrode potential of battery B1. Sixth switching element 35 is in the ON state and fifth switching element 34 is in the OFF state, and thus negative electrode potential VN of capacitor 30 is fixed to the negative electrode potential of battery B1 (the positive electrode potential of battery B2). The voltage of capacitor 30 equals the voltage of battery B1, no battery current flows, and both detection voltage Vc1 and detection voltage Vc2 are zero.

At time t0, when the period enters period T1 in which control signal Vs goes to the H-level, the drive signals become such that Vg3 is equal to reference clock CK0, Vg4 is equal to the inversion of reference clock CK0, Vg5 is at the H level, and Vg6 is at the L level. Since fifth switching element 34 is in the ON state and sixth switching element 35 is in the OFF state, negative electrode potential VN of capacitor 30 is fixed to the negative electrode potential of battery B2, and a switching operation is performed in which third switching element 31 and fourth switching element 32 are alternately turned on and off. From time t0 to t1, drive signal Vg3 is at the H level and drive signal Vg4 is at the L level, and thus third switching element 31 is in the ON state and fourth switching element 32 is in the OFF state, currents I1 and I2 flow, and capacitor 30 is charged to the sum voltage of battery B1 and battery B2.

Next, during time t1 to t2, drive signal Vg3 is at the L level and drive signal Vg4 is at the H level, and thus third switching element 31 enters the OFF state and fourth switching element 32 enters the ON state, current I2 flows, and capacitor 30 is discharged down to the voltage of battery B2. As described above, during period T1, battery B1 repeatedly performs discharge operations at the frequency of reference clock CK0, and battery B2 repeatedly performs charge and discharge operations at the frequency of reference clock CK0.

At time t3, when the period enters period T2 in which control signal Vs is at the L level, the drive signals become such that Vg3 is at the L level, Vg4 is at the H level, Vg5 is at the H level, and Vg6 is at the L level. Since fifth switching element 34 is in the ON state and sixth switching element 35 is in the OFF state, negative electrode potential VN of capacitor 30 remains fixed to the negative electrode potential of battery B2, and since third switching element 31 is in the OFF state and fourth switching element 32 is in the ON state, positive electrode potential VP of capacitor 30 is fixed to the negative electrode potential of battery B1 (the positive electrode potential of battery B2), and the voltage of capacitor 30 equals the voltage of battery B2. No battery current flows, and both detection voltage Vc1 and detection voltage Vc2 are zero.

At time t4, when the period enters period T3 in which control signal Vs is at the H level and frequency-divided signal Vs1 is at the L level, the drive signals become such that Vg3 is at the H level, Vg4 is at the L level, Vg5 is equal to reference clock CK0, and Vg6 is equal to the inversion of reference clock CK0. Since third switching element 31 is in the ON state and fourth switching element 32 is in the OFF state, positive electrode potential VP of capacitor 30 is fixed to the positive electrode potential of battery B1, and a switching operation is performed in which fifth switching element 34 and sixth switching element 35 are alternately turned on and off.

From time t4 to t5, drive signal Vg5 is at the H level and drive signal Vg6 is at the L level, and thus fifth switching element 34 is in the ON state, sixth switching element 35 is in the OFF state, currents I1 and I2 flow, and capacitor 30 is charged to the sum voltage of battery B1 and battery B2.

Next, during time t5 to t6, drive signal Vg5 is at the L level and drive signal Vg6 is at the H level, and thus fifth switching element 34 is placed in the OFF state, sixth switching element 35 is placed in the ON state, current I2 flows, and capacitor 30 is discharged down to the voltage of battery B1. Thus, in period T3, battery B1 repeatedly performs charge and discharge operations at the frequency of reference clock CK0, and battery B2 repeatedly performs discharge operations at the frequency of reference clock CK0.

At time t7, when control signal Vs is at the L level, the drive signals become such that Vg3 is at the H level, Vg4 is at the L level, Vg5 is at the L level, and Vg6 is at the H level, and the period returns to period T0.

As described above, batteries B1 and B2 are repeatedly charged and discharged with pulsed currents to capacitor 30 according to control signal Vs. Current I1 through battery B1 is converted by detection resistor 33 into detection voltage Vc1 and input to current measurer 41 of drive measurement circuit 4, and current I2 through battery B2 is converted by detection resistor 36 into detection voltage Vc2 and input to current measurer 51 of drive measurement circuit 5. While measuring AC impedance, in the H-level period of control signal Vs, impedance measurement device 3 repeats charging from batteries B1 and B2 to capacitor 30 and discharging from capacitor 30 to either battery B1 or battery B2, and in the L-level period of control signal Vs, the charging and discharging by switching operation is stopped. Although the efficiency is not as high as in Embodiment 1 in which inductor 14 is used as the energy storage element, compared with conventional methods in which resistive elements are used to superimpose current on the batteries, loss can be reduced and switching operation in which the voltage of capacitor 30 is also stable can be performed.

As described above, AC detector 42 receives, from higher-level system 200 having a function to calculate AC impedance, a measurement instruction signal including information on a measurement frequency, measures AC voltage and AC current corresponding to the measurement frequency, based on measurement results obtained by voltage measurers 40 and 50 and measurement results obtained by current measurers 41 and 51, and outputs the AC voltage measured and the AC current measured to higher-level system 200. Further, drive controller 23 drives the plurality of switching elements (here, third switching element 31, fourth switching element 32, fifth switching element 34, and sixth switching element 35) to periodically change, in accordance with the measurement frequency, a state of electrical energy transfer via capacitor 30.

Accordingly, since the state of electrical energy transfer between battery B1 and battery B2 is periodically changed in accordance with the measurement frequency, AC voltage and AC current corresponding to the measurement frequency can be measured, and the AC impedance of batteries B1 and B2 can be measured. At this time, the state of electrical energy transfer can be changed via single capacitor 30 provided in impedance measurement device 3, so that, unlike the method disclosed in PLT 2, both an inductor and an energy storage device (capacitor) are not required. Thus, impedance measurement device 3 can be miniaturized. In other words, the AC impedances of series-connected batteries B1 and B2 can be appropriately obtained with a small number of components.

Drive controllers 43 and 53 may alternately place third switching element 31 and fourth switching element 32 in an ON state at a frequency higher than the measurement frequency, may alternately place fifth switching element 34 and sixth switching element 35 in an ON state at a frequency higher than the measurement frequency, and may prevent fourth switching element 32 and sixth switching element 35 from being simultaneously in the ON state.

Accordingly, the time for accumulating charge in capacitor 30 at one time can be shortened. In other words, since a large-capacity capacitor is not required, capacitor 30 can be miniaturized, and consequently impedance measurement device 3 can be miniaturized.

Drive controllers 43 and 53 may control third switching element 31, fourth switching element 32, fifth switching element 34, and sixth switching element 35 so as to repeat, in a cycle corresponding to the measurement frequency, a first energy transfer state, a second energy transfer state, and a stopped state. Here, the first energy transfer state is a state in which, as shown by period T3 in FIG. 9, third switching element 31 is fixed in the ON state, fourth switching element 32 is fixed in the OFF state, fifth switching element 34 and sixth switching element 35 are alternately placed in the ON state at a frequency higher than the measurement frequency, and charging battery B1 when sixth switching element 35 is on and discharging batteries B1 and B2 when fifth switching element 34 is on are repeated. The second energy transfer state is a state in which, as shown by period T1 in FIG. 9, fifth switching element 34 is fixed in the ON state, sixth switching element 35 is fixed in the OFF state, third switching element 31 and fourth switching element 32 are alternately placed in the ON state at a frequency higher than the measurement frequency, and discharging batteries B1 and B2 when third switching element 31 is on and charging battery B2 when fourth switching element 32 is on are repeated. The stopped state is a state in which batteries B1 and B2 are neither charged nor discharged, as shown by periods T0 and T2 in FIG. 9.

In the first energy transfer state, since battery B1 repeatedly charges and discharges, the average value of the current through battery B1 in the first energy transfer state is approximately zero, and the current through battery B1 cannot be measured. On the other hand, in the second energy state, battery B1 repeatedly discharges, so the current through battery B1 can be measured. In the second energy transfer state, since battery B2 repeatedly charges and discharges, the average value of the current through battery B2 in the second energy transfer state is approximately zero, and the current through battery B2 cannot be measured. On the other hand, in the first energy state, battery B2 repeatedly discharges, so the current through battery B2 can be measured. Thus, the AC current through battery B1 and the AC current through battery B2 can be measured by repeating the first energy transfer state, the stopped state, and the second energy transfer state. Note that this control method is useful when the voltage of battery B1 and the voltage of battery B2 are approximately equal.

Note that the device can be further miniaturized and generalized by integrating part or the entirety of drive measurement circuit 4 according to Embodiment 3 and part or the entirety of drive measurement circuit 5 according to Embodiment 3 each into an integrated circuit.

### [Embodiment 4]

In Embodiment 3, series-connected batteries B1 and B2 have substantially the same voltage. Accordingly, in order to charge and discharge capacitor 30, which is the energy storage element, during the H period of control signal Vs, switching operations are repeated to charge capacitor 30 from the two series-connected batteries and discharge to one of the batteries, using frequency-divided signal Vs1. On the other hand, when battery B1 and battery B2 have different voltages, when, for example, the voltage of battery B1 is higher than the voltage of battery B2, the basic configuration of impedance measurement device 3 similar to the one shown in FIG. 7 can be used to repeatedly perform switching operations that charge capacitor 30 from battery B1 and discharge to battery B2.

The impedance measurement device according to Embodiment 4 has a basic configuration similar to the one in FIG. 7, but in order to distinguish it from impedance measurement device 3 according to Embodiment 3, drive measurement circuit 4, drive measurement circuit 5, and communicator 6 in FIG. 7 are denoted respectively as drive measurement circuit 4A, drive measurement circuit 5A, and communicator 6A.

FIG. 10 is a circuit configuration diagram showing examples of drive controllers 43A and 53A of the impedance measurement device according to Embodiment 4. FIG. 10 shows drive controller 43A of drive measurement circuit 4A, drive controller 53A of drive measurement circuit 5A, and part of the internal configuration of communicator 6A. In FIG. 10, the difference between drive controller 43A and drive controller 43 in FIG. 8 is that frequency divider circuit 431, frequency-divided signal Vs1, inverter 433, and OR circuit 434 are absent, and the configuration of AND circuit 432 has been changed to AND circuit 432A. Also, since communicator 6A for sharing signals with drive controller 53A does not have frequency-divided signal Vs1, communicator 6A includes one fewer level-shift circuit than communicator 6 in FIG. 8. Further, the difference between drive controller 53A and drive controller 53 in FIG. 8 is that inverter 531 and OR circuit 534 are absent, and the configuration of AND circuit 532 has been changed to AND circuit 532A.

Oscillator 430 is the same as that in FIG. 8 and outputs reference clock CK0 with a 50% duty ratio, which sets the switching period. Reference clock CK0 and control signal Vs from higher-level system 200 are input to AND circuit 432A. The output of AND circuit 432A is input to AND circuit 439, and the output of AND circuit 439 becomes drive signal Vg3 that drives third switching element 31. The inverted signal obtained from the output of AND circuit 432A via inverter 435 becomes drive signal Vg4 that drives fourth switching element 32 through AND circuit 440.

The configuration in which abnormality signal Fail1 from abnormality detection circuit 436 is input to AND circuit 438 together with enable signal EN via NOR circuit 437, and the output of AND circuit 438 is input to AND circuits 439 and 440, is the same as that in FIG. 8. Thus, if there is no abnormality and a measurement instruction is received from higher-level system 200, when control signal Vs is at the H level, third switching element 31 and fourth switching element 32 are alternately driven on and off in accordance with reference clock CK0, and when control signal Vs is at the L level, third switching element 31 is turned off and fourth switching element 32 is placed in the ON state.

Note that although it is not shown, to prevent third switching element 31 and fourth switching element 32 from being simultaneously placed in the ON state, a dead time during which drive signals Vg3 and Vg4 are simultaneously off is normally provided, which is the same as in FIG. 8.

As shown in drive controller 53A in FIG. 10, reference clock CK0 and control signal Vs are input to AND circuit 532A. Here, reference clock CK0 is obtained from drive controller 43A via the level shifting circuit of communicator 6A, and control signal Vs is input from higher-level system 200. Control signal Vs input to drive measurement circuit 4 and control signal Vs input to drive measurement circuit 5 are signals of the same logic, but it is assumed that one of the signals is level-shifted. The output of AND circuit 532A is input to AND circuit 539, and the output of AND circuit 539 becomes drive signal Vg6 that drives sixth switching element 35. The inverted signal obtained from the output of AND circuit 532A via inverter 535 becomes drive signal Vg5 that drives fifth switching element 34 through AND circuit 540. Drive signals Vg5 and Vg6 are swapped compared to FIG. 8.

The configuration in which abnormality signal Fail2 from abnormality detection circuit 536 is input to AND circuit 538 together with enable signal EN via NOR circuit 537, and the output of AND circuit 538 is input to AND circuits 539 and 540 is the same as that in FIG. 8. That is, if there is no abnormality and a measurement instruction is received from higher-level system 200, when control signal Vs is at the H level, fifth switching element 34 and sixth switching element 35 are alternately driven on and off in accordance with reference clock CK0, and when control signal Vs is at the L level, sixth switching element 35 is turned off and fifth switching element 34 is placed in the ON state.

Note that although it is not shown, to prevent fifth switching element 34 and sixth switching element 35 from being simultaneously placed in the ON state, a dead time during which drive signals Vg5 and Vg6 are simultaneously off is normally provided. Here, a delay time corresponding to the dead time is provided at the rising edge of each drive signal, which is also the same as in FIG. 8.

FIG. 11 is a timing chart illustrating an example of the operation of the impedance measurement device according to Embodiment 4. FIG. 11 is a timing chart showing the operation of principal part of drive controller 43A and drive controller 53A, and shows reference clock CK0, control signal Vs, drive signal Vg3, drive signal Vg4, drive signal Vg5, drive signal Vg6, detection voltage Vc1, detection voltage Vc2, and positive electrode potential VP and negative electrode potential VN of capacitor 30. Although not shown, enable signal EN is at the H level and abnormality signal Fail1 and abnormality signal Fail2 are both at the L level. Detection voltage Vc1 corresponds to current I1 flowing through battery B1 and third switching element 31, and detection voltage Vc2 corresponds to current I2 flowing through battery B2 and fifth switching element 34. In the following, operation in which the impedance measurement device according to Embodiment 4 causes high-frequency current pulses to flow through batteries B1 and B2 will be described with reference to FIG. 11.

As shown in FIG. 11, during period T0, since control signal Vs is at the L level, the drive signals become such that Vg3 is at the L level, Vg4 is at the H level, Vg5 is at the H level, and Vg6 is at the L level. Third switching element 31 is in the OFF state and fourth switching element 32 is in the ON state, so positive electrode potential VP of capacitor 30 is fixed to negative electrode potential VB of battery B1. Sixth switching element 35 is in the OFF state and fifth switching element 34 is in the ON state, so negative electrode potential VN of capacitor 30 is fixed to the negative electrode potential of battery B2. The voltage of capacitor 30 equals the voltage of battery B2, no battery current flows, and both detection voltage Vc1 and detection voltage Vc2 are zero.

At time t0, when the period enters period T1 during which control signal Vs is at the H level, a switching operation is performed in which the drive signals become such that Vg3 and Vg6 are equal to reference clock CK0, and Vg4 and Vg5 are equal to the inversion of reference clock CK0, third switching element 31 and fourth switching element 32 alternately turn on and off, and fifth switching element 34 and sixth switching element 35 alternately turn on and off. During the period from time t0 to t1, since drive signals Vg3 and Vg6 are at the H level, third switching element 31 and sixth switching element 35 are in the ON state, and current I1 flows to charge capacitor 30 to the voltage of battery B1.

Next, during the period from time t1 to t2, since drive signals Vg4 and Vg5 are at the H level, fourth switching element 32 and fifth switching element 34 are in the ON state, and current I2 flows to discharge capacitor 30 to the voltage of battery B2. Thus, in period T1, battery B1 repeatedly performs discharge operations at the frequency of reference clock CK0, and battery B2 repeatedly performs a charge operation at the frequency of reference clock CK0.

At time t3, when the period enters period T2 in which control signal Vs is at the L level, the drive signals become such that Vg3 is at the L level, Vg4 is at the H level, Vg5 is at the H level, and Vg6 is at the L level, which is the same as period T0.

As described above, in accordance with control signal Vs, battery B1 is discharged repeatedly and battery B2 is charged repeatedly by pulse currents to capacitor 30. Current I1 through battery B1 is converted by detection resistor 33 into detection voltage Vc1 and input to current measurer 41 of drive measurement circuit 4A, and current I2 through battery B2 is converted by detection resistor 36 into detection voltage Vc2 and input to current measurer 51 of drive measurement circuit 5A. While measuring AC impedance, the impedance measurement device according to Embodiment 4 repeats the switching operation that discharges battery B1 and charges battery B2 via capacitor 30 during the H level period of control signal Vs, and stops the charge/discharge by switching operation during the L level period of control signal Vs. Compared with conventional methods in which resistive elements are used to superimpose current on the batteries, loss can be reduced and switching operation in which the voltage of capacitor 30 is also stable can be performed.

As described above, drive controllers 43A and 53A may control third switching element 31, fourth switching element 32, fifth switching element 34, and sixth switching element 35 so as to repeat the first energy transfer state and the stopped state in a cycle corresponding to the measurement frequency. Here, as shown by period T1 in FIG. 11, the first energy transfer state is a state in which third switching element 31 and fourth switching element 32 are alternately placed in the ON state at a frequency higher than the measurement frequency, fifth switching element 34 and sixth switching element 35 are alternately placed in the ON state at a frequency higher than the measurement frequency, a switching phase of third switching element 31 and a switching phase of sixth switching element 35 are in phase, a switching phase of fourth switching element 32 and a switching phase of fifth switching element 34 are in phase, and discharging battery B1 and charging battery B2 via capacitor 30 are repeated or charging battery B1 and discharging battery B2 via capacitor 30 are repeated. The stopped state is a state in which batteries B1 and B2 are not charged or discharged, as shown by periods T0 and T2 in FIG. 11.

Since battery B1 repeatedly discharges, the current through battery B1 can be measured, and since battery B2 repeatedly charges, the current through battery B2 can be measured. Thus, the AC current through battery B1 and the AC current through battery B2 can be each measured by repeating the first energy transfer state and the stopped state. Note that this control method is useful when the voltage of battery B1 is higher than the voltage of battery B2. When the voltage of battery B1 is lower than the voltage of battery B2, the above charging and discharging relationship is reversed.

Note that the device can be further miniaturized and generalized by integrating part or the entirety of drive measurement circuit 4A according to Embodiment 4 and part or the entirety of drive measurement circuit 5A according to Embodiment 4 each into an integrated circuit.

### [Other Embodiments]

The above has described embodiments as examples of the technology according to the present disclosure. However, the technology according to the present disclosure is not limited to this, and is also applicable to embodiments as a result of appropriate modification, replacement, addition, and omission, for instance. For example, variations as below are also included in embodiments of the present disclosure.

For example, the present disclosure can be implemented not only as a drive measurement circuit but also as a drive measurement method that includes steps (processes) performed by elements included in the drive measurement circuit.

FIG. 12 is a flowchart showing an example of a drive measurement method according to another embodiment.

A drive measurement method is a method for controlling an impedance measurement device that measures alternating-current (AC) impedance of a first battery and AC impedance of a second battery, the first battery and the second battery being connected in series. The impedance measurement device includes: an energy storage element that stores or releases electrical energy; a switching circuit that intermittently transfers, via the energy storage element, electrical energy between the first battery and the second battery, the switching circuit including a plurality of switching elements; and a current detector that detects current through the first battery and current through the second battery. As shown by FIG. 12, the drive measurement method includes: receiving, from a higher-level system having a function to calculate AC impedance, a measurement instruction signal including information on a measurement frequency (step S11); driving the plurality of switching elements to periodically change, in accordance with the measurement frequency, a state of electrical energy transfer via the energy storage element (step S12); measuring the current through the first battery and the current through the second battery, based on a detection result obtained by the current detector (step S13); measuring voltage of the first battery and voltage of the second battery (step S14); and measuring AC voltage and AC current corresponding to the measurement frequency, based on a measurement result obtained in the measuring of the voltage and a measurement result obtained in the measuring of the current, and outputting the AC voltage measured and the AC current measured to the higher-level system (step S15).

For example, the present disclosure can be realized as a program that causes a computer (processor) to execute the steps included in the drive measurement method. Furthermore, the present disclosure can be realized as a non-transitory computer-readable recording medium, such as a CD-ROM, in which that program is recorded.

For example, when the present disclosure is implemented by a program (software), the steps are performed by executing the program using hardware resources of a computer such as the CPU, memory, and input/output circuits. Thus, the steps are performed by the CPU obtaining data from the memory or the input/output circuits and performing computations, and by outputting computation results to the memory or the input/output circuits.

Note that in the above embodiments, each of the elements included in the drive measurement circuit may be configured by dedicated hardware, or may be realized by executing a software program suitable for the element. Each element may be realized by a program executor such as a CPU or a processor reading and executing a software program stored in a recording medium such as a hard disk or semiconductor memory.

Some or all of the functions of the drive measurement circuit according to the above embodiments are typically realized as a Large Scale Integration (LSI) which is an integrated circuit. These may be implemented as separate single-chip devices, or may be integrated into a single chip that includes some or all of them. Integration is not limited to LSIs and may be realized by dedicated circuits or general-purpose processors. A Field Programmable Gate Array (FPGA), which can be programmed after LSI manufacturing, or a reconfigurable processor that can reconfigure the connections and settings of circuit cells within an LSI may also be used.

Furthermore, if a technology for integrating circuits that replaces LSIs emerges due to advances in semiconductor technology or derived alternative technologies, then, naturally, the elements included in the drive measurement circuit may be integrated using that technology.

The present disclosure also includes embodiments as a result of adding, to the embodiments, various modifications that may be conceived by those skilled in the art, and embodiments achieved by combining elements and functions in the embodiments in any manner without departing from the scope of the present disclosure.

### [Appendix]

The foregoing description of the embodiments discloses the following technologies.

### (Technique 1)

A drive measurement circuit that controls an impedance measurement device that measures alternating-current (AC) impedance of a first battery and AC impedance of a second battery, the first battery and the second battery being connected in series,
wherein the impedance measurement device includes:
an energy storage element that stores or releases electrical energy;
a switching circuit that intermittently transfers, via the energy storage element, electrical energy between the first battery and the second battery, the switching circuit including a plurality of switching elements; and
a current detector that detects current through the first battery and current through the second battery, and
the drive measurement circuit comprises:
   a current measurer that measures the current through the first battery and the current through the second battery, based on a detection result obtained by the current detector;
   a voltage measurer that measures voltage of the first battery and voltage of the second battery;
   an AC detector that receives, from a higher-level system having a function to calculate AC impedance, a measurement instruction signal including information on a measurement frequency, measures AC voltage and AC current corresponding to the measurement frequency, based on a measurement result obtained by the voltage measurer and a measurement result obtained by the current measurer, and outputs the AC voltage measured and the AC current measured to the higher-level system; and
   a drive controller that drives the plurality of switching elements to periodically change, in accordance with the measurement frequency, a state of electrical energy transfer via the energy storage element.

Accordingly, since the state of electrical energy transfer between the first battery and the second battery is periodically changed in accordance with the measurement frequency, AC voltage and AC current corresponding to the measurement frequency can be measured, and the AC impedance of the first battery and the second battery can be measured. At this time, the state of electrical energy transfer can be changed via an energy storage element such as a single inductor or capacitor provided in the impedance measurement device, so that, unlike the method disclosed in PTL 2, both an inductor and an energy storage device (capacitor) are not required. Thus, the impedance measurement device can be miniaturized.

Moreover, since AC impedance can be measured regardless of the relative magnitudes of the voltage of the first battery and the voltage of the second battery, usage constraints are relaxed. Furthermore, since current continuously flows so that charging and discharging between the first battery and the second battery occur without rest periods, the measurement time is shortened and continuous measurement is enabled.

(Technique 2) The drive measurement circuit according to Technique 1,
wherein the first battery and the second battery each include two or more battery cells, and
the voltage measurer simultaneously measures voltages of the two or more battery cells.

Accordingly, the voltages of the first battery and the second battery can be measured in a short time.

(Technique 3) The drive measurement circuit according to Technique 1 or 2,
wherein the energy storage element is an inductor,
the switching circuit includes a first switching element and a second switching element, the first switching element forming a first loop with the first battery and the inductor, the second switching element forming a second loop with the second battery and the inductor, and
the drive controller alternately places the first switching element and the second switching element in an ON state at a frequency higher than the measurement frequency.

Accordingly, by alternately placing the first switching element and the second switching element in the ON state at a frequency higher than the measurement frequency, the duration during which current flows through the inductor at one time can be shortened. In other words, since a large current is less likely to flow through the inductor, the inductor can be miniaturized, and consequently the impedance measurement device can be miniaturized.

(Technique 4) The drive measurement circuit according to Technique 3,
wherein the current detector includes a first detection resistor connected between the first battery and the first switching element and a second detection resistor connected between the second battery and the second switching element.

Accordingly, the current through the first battery can be detected by detecting the current flowing through the first detection resistor, and the current through the second battery can be detected by detecting the current flowing through the second detection resistor.

(Technique 5) The drive measurement circuit according to Technique 3,
wherein the current detector includes one of a first detection resistor or a second detection resistor, and a third detection resistor, the first detection resistor being connected between the first battery and the first switching element, the second detection resistor being connected between the second battery and the second switching element, the third detection resistor being connected in series with the inductor.

Accordingly, by detecting the current flowing through one of the first detection resistor or the second detection resistor, the current through one of the first battery and the second battery can be detected. Further, since the current flowing through the third detection resistor is the difference between the current through the second battery and the current flowing through the first battery, the current through the other battery of the first and second batteries can be detected by calculating the sum of the current flowing through the above-mentioned one detection resistor and the current flowing through the third detection resistor.

(Technique 6) The drive measurement circuit according to any one of Techniques 3 to 5,
wherein the drive controller controls an ON time of the first switching element and an ON time of the second switching element to cause a first energy transfer state and a second energy transfer state to repeat in a cycle corresponding to the measurement frequency, the first energy transfer state being a state in which drawing discharge current from the first battery when the first switching element is on and supplying charge current to the second battery when the second switching element is on are repeated, the second energy transfer state being a state in which drawing discharge current from the second battery when the second switching element is on and supplying charge current to the first battery when the first switching element is on are repeated.

Accordingly, by lengthening the on-time of the second switching element, a discharge current can be caused to start flowing from the second battery, and as a result, it is possible to switch from the first energy transfer state to the second energy transfer state. Further, by lengthening the on-time of the first switching element, a discharge current can be caused to start flowing from the first battery, and as a result, it is possible to switch from the second energy transfer state to the first energy transfer state.

(Technique 7) The drive measurement circuit according to Technique 6,
wherein the drive controller limits a peak value of the discharge current from the first battery to a predetermined value in the first energy transfer state, and limits a peak value of the discharge current from the second battery to a predetermined value in the second energy transfer state.

By doing so, the discharge current from the first battery and the discharge current from the second battery can be limited, thereby inhibiting switching losses that occur during switching.

(Technique 8) The drive measurement circuit according to any one of Techniques 3 to 7, wherein the switching circuit includes a current interrupter connected in series with the inductor, and the drive controller interrupts current flowing through the current interrupter when the detection result obtained by the current detector exceeds a predetermined amount.

According to this, the current can be interrupted when an overcurrent flows.

(Technique 9) The drive measurement circuit according to Technique 1 or 2,
wherein the energy storage element is a capacitor,
the switching circuit includes a third switching element, a fourth switching element, a fifth switching element, and a sixth switching element, the third switching element being connected between a positive electrode of the first battery and a positive electrode of the capacitor, the fourth switching element being connected between a negative electrode of the first battery and the positive electrode of the capacitor, the fifth switching element being connected between a negative electrode of the second battery and a negative electrode of the capacitor, the sixth switching element being connected between a positive electrode of the second battery and the negative electrode of the capacitor, and
the drive controller alternately places the third switching element and the fourth switching element in an ON state at a frequency higher than the measurement frequency, alternately places the fifth switching element and the sixth switching element in an ON state at a frequency higher than the measurement frequency, and prevents the fourth switching element and the sixth switching element from being simultaneously in the ON state.

Accordingly, the time for accumulating charge in the capacitor at one time can be shortened by alternately placing the third switching element and the fourth switching element in the ON state at a frequency higher than the measurement frequency, and by alternately placing the fifth switching element and the sixth switching element in the ON state at a frequency higher than the measurement frequency. In other words, since a large-capacity capacitor is not required, the capacitor can be miniaturized, and consequently the impedance measurement device can be miniaturized.

(Technique 10) The drive measurement circuit according to Technique 9,
wherein the current detector includes a first detection resistor and a second detection resistor, the first detection resistor being connected between the first battery and the third switching element, the second detection resistor being connected between the second battery and the fifth switching element.

Accordingly, the current through the first battery can be detected by detecting the current flowing through the first detection resistor, and the current through the second battery can be detected by detecting the current flowing through the second detection resistor.

(Technique 11) The drive measurement circuit according to Technique 9 or 10,
wherein the drive controller controls the third switching element, the fourth switching element, the fifth switching element, and the sixth switching element to cause a first energy transfer state, a second energy transfer state, and a stopped state to repeat in a cycle corresponding to the measurement frequency, the first energy transfer state being a state in which the third switching element is fixed in the ON state, the fourth switching element is fixed in an OFF state, the fifth switching element and the sixth switching element are alternately placed in the ON state at the frequency higher than the measurement frequency, and charging the first battery when the sixth switching element is on and discharging the first battery and the second battery when the fifth switching element is on are repeated, the second energy transfer state being a state in which the fifth switching element is fixed in the ON state, the sixth switching element is fixed in an OFF state, the third switching element and the fourth switching element are alternately placed in the ON state at the frequency higher than the measurement frequency, and discharging the first battery and the second battery when the third switching element is on and charging the second battery when the fourth switching element is on are repeated, the stopped state being a state in which the first battery and the second battery are neither charged nor discharged.

According to this, in the first energy transfer state, since the first battery repeatedly charges and discharges, the average value of the current through the first battery in the first energy transfer state is approximately zero, and the current through the first battery cannot be measured. On the other hand, in the second energy state, the first battery repeatedly discharges, so the current through the first battery can be measured. In addition, in the second energy transfer state, since the second battery repeatedly charges and discharges, the average value of the current through the second battery in the second energy transfer state is approximately zero, and the current through the second battery cannot be measured. On the other hand, in the first energy state, the second battery repeatedly discharges, and thus the current through the second battery can be measured. Thus, the AC current through the first battery and the AC current through the second battery can be measured by repeating the first energy transfer state, the stopped state, and the second energy transfer state. Note that this control method is useful when the voltage of the first battery and the voltage of the second battery are approximately equal.

(Technique 12) The drive measurement circuit according to claim 9 or 10,
wherein the drive controller controls the third switching element, the fourth switching element, the fifth switching element, and the sixth switching element to cause a first energy transfer state and a stopped state to repeat in a cycle corresponding to the measurement frequency, the first energy transfer state being a state in which the third switching element and the fourth switching element are alternately placed in the ON state at the frequency higher than the measurement frequency, the fifth switching element and the sixth switching element are alternately placed in the ON state at the frequency higher than the measurement frequency, a switching phase of the third switching element and a switching phase of the sixth switching element are in phase, a switching phase of the fourth switching element and a switching phase of the fifth switching element are in phase, and discharging the first battery and charging the second battery via the capacitor are repeated or charging the first battery and discharging the second battery via the capacitor are repeated, the stopped state being a state in which the first battery and the second battery are neither charged nor discharged.

Accordingly, since the first battery repeatedly discharges, the current through the first battery can be measured, and since the second battery repeatedly charges, the current through the second battery can be measured. Thus, the AC current through the first battery and the AC current through the second battery can be measured by repeating the first energy transfer state and the stopped state. Note that this control method is useful when the voltage of the first battery is higher than the voltage of the second battery.

(Technique 13) The drive measurement circuit according to any one of Techniques 1 to 12,
wherein at least the current measurer, the voltage measurer, the AC detector, and the drive controller are integrated into an integrated circuit.

As stated above, the current measurer, the voltage measurer, the AC detector, and the drive controller may be integrated into an integrated circuit.

(Technique 14) An impedance measurement device that measures alternating-current (AC) impedance of a first battery and AC impedance of a second battery, the first battery and the second battery being connected in series, the impedance measurement device comprising:
an energy storage element that stores or releases electrical energy;
a switching circuit that intermittently transfers, via the energy storage element, electrical energy between the first battery and the second battery, the switching circuit including a plurality of switching elements;
a current detector that detects current through the first battery and current through the second battery; and
a drive measurement circuit,
wherein the drive measurement circuit includes:
   a current measurer that measures the current through the first battery and the current through the second battery, based on a detection result obtained by the current detector;
   a voltage measurer that measures voltage of the first battery and voltage of the second battery;
   an AC detector that receives, from a higher-level system having a function to calculate AC impedance, a measurement instruction signal including information on a measurement frequency, measures AC voltage and AC current corresponding to the measurement frequency, based on a measurement result obtained by the voltage measurer and a measurement result obtained by the current measurer, and outputs the AC voltage measured and the AC current measured to the higher-level system; and
   a drive controller that drives the plurality of switching elements to periodically change, in accordance with the measurement frequency, a state of electrical energy transfer via the energy storage element.

Accordingly, a compact impedance measurement device can be provided.

(Technique 15) An impedance measurement system comprising:
an impedance measurement device that measures alternating-current (AC) impedance of a first battery and AC impedance of a second battery, the first battery and the second battery being connected in series;
a drive measurement circuit that controls the impedance measurement device; and
a higher-level system having a function to calculate AC impedance,
wherein the impedance measurement device includes:
   an energy storage element that stores or releases electrical energy;
   a switching circuit that intermittently transfers, via the energy storage element, electrical energy between the first battery and the second battery, the switching circuit including a plurality of switching elements; and
   a current detector that detects current through the first battery and current through the second battery, and
   the drive measurement circuit includes:
      a current measurer that measures the current through the first battery and the current through the second battery, based on a detection result obtained by the current detector;
      a voltage measurer that measures voltage of the first battery and voltage of the second battery;
      an AC detector that receives, from the higher-level system, a measurement instruction signal including information on a measurement frequency, measures AC voltage and AC current corresponding to the measurement frequency, based on a measurement result obtained by the voltage measurer and a measurement result obtained by the current measurer, and outputs the AC voltage measured and the AC current measured to the higher-level system; and
      a drive controller that drives the plurality of switching elements to periodically change, in accordance with the measurement frequency, a state of electrical energy transfer via the energy storage element.

Accordingly, a compact impedance measurement system can be provided.

(Technique 16) A drive measurement method for controlling an impedance measurement device that measures alternating-current (AC) impedance of a first battery and AC impedance of a second battery, the first battery and the second battery being connected in series,
wherein the impedance measurement device includes:
an energy storage element that stores or releases electrical energy;
a switching circuit that intermittently transfers, via the energy storage element, electrical energy between the first battery and the second battery, the switching circuit including a plurality of switching elements; and
a current detector that detects current through the first battery and current through the second battery, and
the drive measurement method comprises:
   receiving, from a higher-level system having a function to calculate AC impedance, a measurement instruction signal including information on a measurement frequency;
   driving the plurality of switching elements to periodically change, in accordance with the measurement frequency, a state of electrical energy transfer via the energy storage element;
   measuring the current through the first battery and the current through the second battery, based on a detection result obtained by the current detector;
   measuring voltage of the first battery and voltage of the second battery; and
   measuring AC voltage and AC current corresponding to the measurement frequency, based on a measurement result obtained in the measuring of the voltage and a measurement result obtained in the measuring of the current, and outputting the AC voltage measured and the AC current measured to the higher-level system.

Accordingly, a drive measurement method with which the impedance measurement device can be miniaturized can be provided.

### [Industrial Applicability]

The present disclosure is useful as an impedance measurement device for diagnosing battery degradation.

### [Reference Signs List]

1, 1A, 3 impedance measurement device
2, 2A, 4, 4A, 5, 5A drive measurement circuit
6, 6A, 224 communicator
11 first switching element
12 second switching element
13 current interrupter
14 inductor
15, 16, 17, 33, 36 detection resistor
20, 40, 50 voltage measurer
21, 21A, 41, 51 current measurer
22, 42, 52 AC detector
23, 43, 43A, 53, 53A drive controller
30 capacitor
31 third switching element
32 fourth switching element
34 fifth switching element
35 sixth switching element
100 impedance measurement system
200 higher-level system
210 adder
220 signal generator
221 converter
222 integrator
223 holder
230, 430 oscillator
231, 232 reference voltage source
233, 234 comparator
235, 434, 534 OR circuit
236 SR latch
237, 238 switch circuit
239, 436, 536 abnormality detection circuit
240, 433, 435, 531, 535 inverter
241, 242, 243, 432, 432A, 438, 439, 440, 532, 532A, 538, 539, 540 AND circuit
431 frequency divider circuit
437, 537 NOR circuit
B1, B2 battery

## Claims

1. A drive measurement circuit that controls an impedance measurement device that measures alternating-current (AC) impedance of a first battery and AC impedance of a second battery, the first battery and the second battery being connected in series,
wherein the impedance measurement device includes:
an energy storage element that stores or releases electrical energy;
a switching circuit that intermittently transfers, via the energy storage element, electrical energy between the first battery and the second battery, the switching circuit including a plurality of switching elements; and
a current detector that detects current through the first battery and current through the second battery, and
the drive measurement circuit comprises:
a current measurer that measures the current through the first battery and the current through the second battery, based on a detection result obtained by the current detector;
a voltage measurer that measures voltage of the first battery and voltage of the second battery;
an AC detector that receives, from a higher-level system having a function to calculate AC impedance, a measurement instruction signal including information on a measurement frequency, measures AC voltage and AC current corresponding to the measurement frequency, based on a measurement result obtained by the voltage measurer and a measurement result obtained by the current measurer, and outputs the AC voltage measured and the AC current measured to the higher-level system; and
a drive controller that drives the plurality of switching elements to periodically change, in accordance with the measurement frequency, a state of electrical energy transfer via the energy storage element.

2. The drive measurement circuit according to claim 1,
wherein the first battery and the second battery each include two or more battery cells, and
the voltage measurer simultaneously measures voltages of the two or more battery cells.

3. The drive measurement circuit according to claim 1 or 2,
wherein the energy storage element is an inductor,
the switching circuit includes a first switching element and a second switching element, the first switching element forming a first loop with the first battery and the inductor, the second switching element forming a second loop with the second battery and the inductor, and
the drive controller alternately places the first switching element and the second switching element in an ON state at a frequency higher than the measurement frequency.

4. The drive measurement circuit according to claim 3,
wherein the current detector includes a first detection resistor connected between the first battery and the first switching element and a second detection resistor connected between the second battery and the second switching element.

5. The drive measurement circuit according to claim 3,
wherein the current detector includes one of a first detection resistor or a second detection resistor, and a third detection resistor, the first detection resistor being connected between the first battery and the first switching element, the second detection resistor being connected between the second battery and the second switching element, the third detection resistor being connected in series with the inductor.

6. The drive measurement circuit according to any one of claims 3 to 5,
wherein the drive controller controls an ON time of the first switching element and an ON time of the second switching element to cause a first energy transfer state and a second energy transfer state to repeat in a cycle corresponding to the measurement frequency, the first energy transfer state being a state in which drawing discharge current from the first battery when the first switching element is on and supplying charge current to the second battery when the second switching element is on are repeated, the second energy transfer state being a state in which drawing discharge current from the second battery when the second switching element is on and supplying charge current to the first battery when the first switching element is on are repeated.

7. The drive measurement circuit according to claim 6,
wherein the drive controller limits a peak value of the discharge current from the first battery to a predetermined value in the first energy transfer state, and limits a peak value of the discharge current from the second battery to a predetermined value in the second energy transfer state.

8. The drive measurement circuit according to any one of claims 3 to 7,
wherein the switching circuit includes a current interrupter connected in series with the inductor, and the drive controller interrupts current flowing through the current interrupter when the detection result obtained by the current detector exceeds a predetermined amount.

9. The drive measurement circuit according to claim 1 or 2,
wherein the energy storage element is a capacitor,
the switching circuit includes a third switching element, a fourth switching element, a fifth switching element, and a sixth switching element, the third switching element being connected between a positive electrode of the first battery and a positive electrode of the capacitor, the fourth switching element being connected between a negative electrode of the first battery and the positive electrode of the capacitor, the fifth switching element being connected between a negative electrode of the second battery and a negative electrode of the capacitor, the sixth switching element being connected between a positive electrode of the second battery and the negative electrode of the capacitor, and
the drive controller alternately places the third switching element and the fourth switching element in an ON state at a frequency higher than the measurement frequency, alternately places the fifth switching element and the sixth switching element in an ON state at a frequency higher than the measurement frequency, and prevents the fourth switching element and the sixth switching element from being simultaneously in the ON state.

10. The drive measurement circuit according to claim 9,
wherein the current detector includes a first detection resistor and a second detection resistor, the first detection resistor being connected between the first battery and the third switching element, the second detection resistor being connected between the second battery and the fifth switching element.

11. The drive measurement circuit according to claim 9 or 10,
wherein the drive controller controls the third switching element, the fourth switching element, the fifth switching element, and the sixth switching element to cause a first energy transfer state, a second energy transfer state, and a stopped state to repeat in a cycle corresponding to the measurement frequency, the first energy transfer state being a state in which the third switching element is fixed in the ON state, the fourth switching element is fixed in an OFF state, the fifth switching element and the sixth switching element are alternately placed in the ON state at the frequency higher than the measurement frequency, and charging the first battery when the sixth switching element is on and discharging the first battery and the second battery when the fifth switching element is on are repeated, the second energy transfer state being a state in which the fifth switching element is fixed in the ON state, the sixth switching element is fixed in an OFF state, the third switching element and the fourth switching element are alternately placed in the ON state at the frequency higher than the measurement frequency, and discharging the first battery and the second battery when the third switching element is on and charging the second battery when the fourth switching element is on are repeated, the stopped state being a state in which the first battery and the second battery are neither charged nor discharged.

12. The drive measurement circuit according to claim 9 or 10,
wherein the drive controller controls the third switching element, the fourth switching element, the fifth switching element, and the sixth switching element to cause a first energy transfer state and a stopped state to repeat in a cycle corresponding to the measurement frequency, the first energy transfer state being a state in which the third switching element and the fourth switching element are alternately placed in the ON state at the frequency higher than the measurement frequency, the fifth switching element and the sixth switching element are alternately placed in the ON state at the frequency higher than the measurement frequency, a switching phase of the third switching element and a switching phase of the sixth switching element are in phase, a switching phase of the fourth switching element and a switching phase of the fifth switching element are in phase, and discharging the first battery and charging the second battery via the capacitor are repeated or charging the first battery and discharging the second battery via the capacitor are repeated, the stopped state being a state in which the first battery and the second battery are neither charged nor discharged.

13. The drive measurement circuit according to any one of claims 1 to 12,
wherein at least the current measurer, the voltage measurer, the AC detector, and the drive controller are integrated into an integrated circuit.

14. An impedance measurement device that measures alternating-current (AC) impedance of a first battery and AC impedance of a second battery, the first battery and the second battery being connected in series, the impedance measurement device comprising:
an energy storage element that stores or releases electrical energy;
a switching circuit that intermittently transfers, via the energy storage element, electrical energy between the first battery and the second battery, the switching circuit including a plurality of switching elements;
a current detector that detects current through the first battery and current through the second battery; and
a drive measurement circuit,
wherein the drive measurement circuit includes:
a current measurer that measures the current through the first battery and the current through the second battery, based on a detection result obtained by the current detector;
a voltage measurer that measures voltage of the first battery and voltage of the second battery;
an AC detector that receives, from a higher-level system having a function to calculate AC impedance, a measurement instruction signal including information on a measurement frequency, measures AC voltage and AC current corresponding to the measurement frequency, based on a measurement result obtained by the voltage measurer and a measurement result obtained by the current measurer, and outputs the AC voltage measured and the AC current measured to the higher-level system; and
a drive controller that drives the plurality of switching elements to periodically change, in accordance with the measurement frequency, a state of electrical energy transfer via the energy storage element.

15. An impedance measurement system comprising:
an impedance measurement device that measures alternating-current (AC) impedance of a first battery and AC impedance of a second battery, the first battery and the second battery being connected in series;
a drive measurement circuit that controls the impedance measurement device; and
a higher-level system having a function to calculate AC impedance,
wherein the impedance measurement device includes:
an energy storage element that stores or releases electrical energy;
a switching circuit that intermittently transfers, via the energy storage element, electrical energy between the first battery and the second battery, the switching circuit including a plurality of switching elements; and
a current detector that detects current through the first battery and current through the second battery, and
the drive measurement circuit includes:
a current measurer that measures the current through the first battery and the current through the second battery, based on a detection result obtained by the current detector;
a voltage measurer that measures voltage of the first battery and voltage of the second battery;
an AC detector that receives, from the higher-level system, a measurement instruction signal including information on a measurement frequency, measures AC voltage and AC current corresponding to the measurement frequency, based on a measurement result obtained by the voltage measurer and a measurement result obtained by the current measurer, and outputs the AC voltage measured and the AC current measured to the higher-level system; and
a drive controller that drives the plurality of switching elements to periodically change, in accordance with the measurement frequency, a state of electrical energy transfer via the energy storage element.

16. A drive measurement method for controlling an impedance measurement device that measures alternating-current (AC) impedance of a first battery and AC impedance of a second battery, the first battery and the second battery being connected in series,
wherein the impedance measurement device includes:
an energy storage element that stores or releases electrical energy;
a switching circuit that intermittently transfers, via the energy storage element, electrical energy between the first battery and the second battery, the switching circuit including a plurality of switching elements; and
a current detector that detects current through the first battery and current through the second battery, and
the drive measurement method comprises:
receiving, from a higher-level system having a function to calculate AC impedance, a measurement instruction signal including information on a measurement frequency;
driving the plurality of switching elements to periodically change, in accordance with the measurement frequency, a state of electrical energy transfer via the energy storage element;
measuring the current through the first battery and the current through the second battery, based on a detection result obtained by the current detector;
measuring voltage of the first battery and voltage of the second battery; and
measuring AC voltage and AC current corresponding to the measurement frequency, based on a measurement result obtained in the measuring of the voltage and a measurement result obtained in the measuring of the current, and outputting the AC voltage measured and the AC current measured to the higher-level system.
